# EUROPEAN PATENT APPLICATION

(11) **EP 4 462 974 A1**
(43) Date of publication of application: **13.11.2024**
(21) Application number: 22918723.2
(22) Date of filing: 16.11.2022
(51) Int. Cl.: H10K 30/50, H10K 30/40, H10K 30/88

(54) **SOLAR CELL**

(30) Priority: 07.01.2022 JP 2022001947
(71) Applicant: Panasonic Holdings Corporation, Osaka, 571-8501 (JP)
(72) Inventor: SEKIMOTO, Takeyuki, Kadoma-shi, Osaka 571-0057 (JP); MATSUI, Taisuke, Kadoma-shi, Osaka 571-0057 (JP); NAKAMURA, Toru, Kadoma-shi, Osaka 571-0057 (JP); KANEKO, Yukihiro, Kadoma-shi, Osaka 571-0057 (JP)
(74) Representative: Grünecker Patent- und Rechtsanwälte PartG mbB
(86) International application number: PCT/JP2022/042633
(87) International publication number: WO 2023/132134

(57) **Abstract**

A solar cell 100 of the present disclosure includes: a photoelectric conversion element 20; and an exterior body 1 surrounding the entire photoelectric conversion element 20. The photoelectric conversion element 20 includes a perovskite compound. The exterior body 1 includes a first sealing portion 30 and a second sealing portion. The first sealing portion 30 includes an oxygen concentration adjusting material. The first sealing portion 30 has a first exposed surface 31 exposed to an outside of the exterior body 1 and a second exposed surface 32 exposed to an inside of the exterior body 1, and is continuous between the first exposed surface 31 and the second exposed surface 32. The second sealing portion includes a material having an oxygen permeability coefficient lower than that of the oxygen concentration adjusting material.

## Description

### TECHNICAL FIELD

The present invention relates to a solar cell.

### BACKGROUND ART

Research and development of perovskite solar cells in which a perovskite crystal represented by a composition formula ABX₃ (where A is a monovalent cation, B is a divalent cation, and X is a halogen anion) or a structure similar thereto (hereinafter referred to as "perovskite compound") is used as a photoelectric conversion material have been conducted in recent years. Various approaches have been made to enhance the photoelectric conversion efficiency and the durability of perovskite solar cells.

Non Patent Literature 1 reports that the cation in a perovskite compound reacts with oxygen under light irradiation to form a metal oxide or a hydroxide on the surface of the perovskite compound and at the grain boundaries in the perovskite compound.

Patent Literature 1 discloses a CdS/CdTe or CdS/CuInSe₂ solar cell module in which a solar cell element is hermetically sealed in an exterior structure having a hole having an oxygen-permeable member therein.

### CITATION LIST

### Patent Literature

Patent Literature 1: JP H2(1990)-170475 A

### Non Patent Literature

Non Patent Literature 1: Q. Sun and eight others, Advanced Energy Materials, July 2017, vol. 7, p. 1700977

### SUMMARY OF INVENTION

### Technical Problem

The present disclosure aims to provide a solar cell having enhanced durability.

### Solution to Problem

A solar cell of the present disclosure includes:
a photoelectric conversion element; and
an exterior body surrounding the entire photoelectric conversion element, wherein
the photoelectric conversion element includes a perovskite compound,
the exterior body includes a first sealing portion and a second sealing portion,
the first sealing portion includes an oxygen concentration adjusting material, has a first exposed surface exposed to an outside of the exterior body and a second exposed surface exposed to an inside of the exterior body, and is continuous between the first exposed surface and the second exposed surface, and
the second sealing portion includes a material having an oxygen permeability coefficient lower than that of the oxygen concentration adjusting material.

### Advantageous Effects of Invention

The present disclosure provides a solar cell having enhanced durability.

### BRIEF DESCRIPTION OF DRAWINGS

FIG. 1 is a cross-sectional view schematically showing a first configuration example of a solar cell of the first embodiment.
FIG. 2 is a cross-sectional view schematically showing a second configuration example of the solar cell of the first embodiment.
FIG. 3 is a cross-sectional view schematically showing a first configuration example of a solar cell of a second embodiment.
FIG. 4 is a cross-sectional view schematically showing a second configuration example of the solar cell of the second embodiment.
FIG. 5 is a cross-sectional view schematically showing a third configuration example of the solar cell of the second embodiment.
FIG. 6 is a cross-sectional view schematically showing a fourth configuration example of the solar cell of the second embodiment.
FIG. 7 is a cross-sectional view schematically showing a fifth configuration example of the solar cell of the second embodiment.
FIG. 8 is a cross-sectional view schematically showing a first configuration example of a solar cell of a third embodiment.
FIG. 9 is a cross-sectional view schematically showing a first configuration example of a solar cell of a fourth embodiment.
FIG. 10 is a cross-sectional view schematically showing a second configuration example of the solar cell of the fourth embodiment.
FIG. 11 is a cross-sectional view schematically showing a third configuration example of the solar cell of the fourth embodiment.
FIG. 12 is a cross-sectional view schematically showing a fourth configuration example of the solar cell of the fourth embodiment.
FIG. 13 is a cross-sectional view schematically showing an example of a photoelectric conversion element 20 of the solar cells according to the embodiments of the present disclosure.

### DESCRIPTION OF EMBODIMENTS

### (Findings on which the present disclosure is based)

As reported in Non Patent Literature 1, a lead-containing perovskite compound reacts with oxygen under light irradiation to form lead oxide (PbO) or lead hydroxide (Pb(OH)₂) on the surface of the perovskite compound and at the grain boundaries in the perovskite compound. Since lead oxide and lead hydroxide each have high electrical insulation properties, lead oxide or lead hydroxide formed on the surface of the perovskite compound and at the grain boundaries in the perovskite compound prevent photogenerated carriers from transferring. That results in deterioration of properties of perovskite solar cells including a lead-containing perovskite compound.

Hence, perovskite solar cells are commonly used in a nitrogen atmosphere where the amount of oxygen is minimized (for example, the oxygen concentration is 0.1 ppm or less in volume fraction).

The terms "water vapor concentration" and "oxygen concentration" each herein refer to the concentration in volume fraction.

According to Non Patent Literature 1, a normalized photoelectric conversion efficiency of a perovskite solar cell after a light irradiation test monotonously decreases as the oxygen concentration around the solar cell increases from 1% to 20%, on the basis of the photoelectric conversion efficiency at an oxygen concentration of 0% around the solar cell.

On the other hand, through detailed investigation of a threshold (i.e., a value at which the effect on the durability becomes noticeable) of the oxygen concentration, the present inventors found that an oxygen concentration range optimal in terms of the durability of a perovskite solar cell is in the range of 0% or more and 1 % or less. Specifically, the electric conversion efficiency after a light irradiation test is the maximum when the oxygen concentration in a sealed space where the water vapor concentration is maintained at 0.1 ppm or less is 10 ppm or more and 3000 ppm or less. Moreover, the present inventors found that the photoelectric conversion efficiency after a thermal resistance test is the maximum when the oxygen concentration in the above sealed space is 100 ppm or more and 3000 ppm or less. That is, both the photostability and the thermal stability of a perovskite solar cell can be achieved when the oxygen concentration in the above sealed space is 100 ppm or more and 3000 ppm or less.

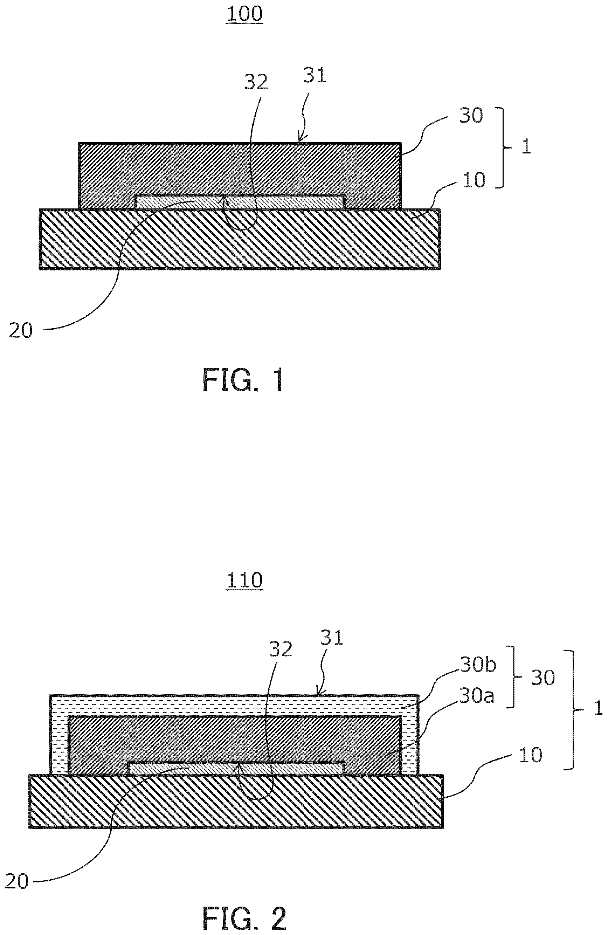

Patent Literature 1 discloses a CdS/CdTe solar cell and a CdS/CuInSe₂ solar cell. The photoelectric conversion efficiencies of CdS/CdTe solar cells and CdS/CuInSe₂ solar cells are known to drop when the oxygen concentration around the solar cell element thereof is low. For example, according to Patent Literature 1, the efficiency drops when the oxygen concentration is 10% or less, 5% or less, or 1% or less. Therefore, the sealing structure disclosed in Patent Literature 1 is a structure for a CdS/CdTe or CdTe/CuInSe₂ solar cell, the structure being for maintaining the oxygen concentration in a sealed space at a high concentration such as 1% or more, 5% or more, or 10% or more. Patent Literature 1 discloses, as a sealing structure being for maintaining a high oxygen concentration, a structure in which a portion of an exterior structure includes an oxygen inlet hole provided with an organic polymer, a water-repellent organic porous material, an inorganic porous material charged with an organic substance, or the like as an oxygen-permeable member. Patent Literature 1 further discloses a structure to which a sheet-shaped silicon resin, a high-density polyethylene sheet, or the like is provided by means of an adhesive to fill such a hole. Refer to FIG. 1 of Patent Literature 1 for the exterior structure of Patent Literature 1.

However, the sealing structure of Patent Literature 1 is a structure for actively taking external air containing oxygen into the sealed space through the hole. Hence, if the sealing structure of Patent Literature 1 is used as a sealing structure of a perovskite solar cell, the oxygen concentration in the sealed space is beyond the range optimal in terms of durability of perovskite solar cells. This results in a disadvantage of a decrease of the durability of the perovskite solar cell.

In the light of these prior techniques, the present inventors have found a solar cell structure for adjusting the oxygen concentration in a region in contact with a photoelectric conversion element to a low concentration. Specifically, the oxygen concentration in a region in contact with a photoelectric conversion element is controlled by taking external air inside through a first sealing portion including an oxygen concentration adjusting material. This structure makes it possible to control the oxygen concentration in an vicinity of the photoelectric conversion element optimally (for example, 10 ppm or more and 3000 ppm or less, or 100 ppm or more and 3000 ppm or less) during an actual operation period, and thus the durability of the solar cell is enhanced.

A solar cell of the present disclosure will be described hereinafter with reference to the drawings. In the drawings, wiring from a photoelectric conversion element, a frame supporting a module, and a terminal box are omitted.

### (First embodiment)

A solar cell of a first embodiment will be described hereinafter.

A solar cell according to each embodiment of the present disclosure includes a photoelectric conversion element and an exterior body surrounding the entire photoelectric conversion element. The photoelectric conversion element includes a perovskite compound. The exterior body includes a first sealing portion and a second sealing portion. The first sealing portion includes an oxygen concentration adjusting material. The first sealing portion has a first exposed surface exposed to an outside of the exterior body and a second exposed surface exposed to an inside of the exterior body, and is continuous between the first exposed surface and the second exposed surface. The second sealing portion includes a material having an oxygen permeability coefficient lower than that of the above oxygen concentration adjusting material.

In the solar cell of the first embodiment, the oxygen concentration in a region in contact with the photoelectric conversion element can be adjusted within the low concentration range suitable for perovskite solar cells since the exterior body includes the first sealing portion and the second sealing portion and the first sealing portion includes the oxygen concentration adjusting material. Consequently, a reaction product of the perovskite compound and oxygen and a decomposition product of the perovskite compound are in proper amounts and do not prevent carriers from transferring. Additionally, the reaction product and the decomposition product in such proper amounts can be stably present on a surface of the perovskite compound or at a grain boundary therein for a long period of time, and can satisfactorily terminate a defect of the photoelectric conversion material. Therefore, photo degradation and thermal degradation phenomena induced by a defect of the photoelectric conversion material are reduced, and the durability of the solar cell can be enhanced.

The oxygen concentration in the region in contact with the photoelectric conversion element may be 10 ppm or more and 3000 ppm or less. A photo degradation phenomenon induced by a defect of the photoelectric conversion material is reduced, and the durability of the solar cell can be enhanced. The oxygen concentration in the region in contact with the photoelectric conversion element may be 100 ppm or more and 3000 ppm or less. Photo degradation and thermal degradation phenomena induced by a defect of the photoelectric conversion material are reduced, and the durability of the solar cell can be further enhanced.

The exterior body may consist of the first sealing portion and the second sealing portion.

The second sealing portion may include a supporting portion supporting the photoelectric conversion element.

The solar cell of the first embodiment will be hereinafter described in more details using first and second configuration examples. The solar cell of the first embodiment is not limited to solar cells of the first and second configuration examples given below.

FIG. 1 is a cross-sectional view schematically showing the first example of the solar cell of the first embodiment.

A solar cell 100 includes a photoelectric conversion element 20 and an exterior body 1. The exterior body 1 includes a second sealing portion and a first sealing portion 30. The second sealing portion is composed of a supporting portion 10 supporting the photoelectric conversion element 20. That is, the second sealing portion includes the supporting portion 10 supporting the photoelectric conversion element 20. The first sealing portion 30 covers a surface of the photoelectric conversion element 20 supported by the supporting portion 10 included in the second sealing portion. The supporting portion 10 included in the second sealing portion may be herein referred to as "supporting portion 10".

The photoelectric conversion element 20 includes a perovskite compound.

The first sealing portion 30 includes an oxygen concentration adjusting material. The first sealing portion 30 has a first exposed surface 31 exposed to an outside of the exterior body 1 and a second exposed surface 32 exposed to an inside of the exterior body 1, and is continuous between the first exposed surface 31 and the second exposed surface 32. This allows oxygen to go in and out of the exterior body 1 through the first sealing portion 30.

The first sealing portion 30 may cover at least a portion of the surface of the photoelectric conversion element 20 supported by the supporting portion 10. The first sealing portion 30 may cover the entire surface of the photoelectric conversion element 20 supported by the supporting portion 10.

The first sealing portion 30 may be in contact with the surface of the photoelectric conversion element 20.

As shown in FIG. 1, the photoelectric conversion element 20 may be sandwiched between the supporting portion 10 and the first sealing portion 30.

The photoelectric conversion element 20 may be in contact with the supporting portion 10. The photoelectric conversion element 20 may be in contact with the supporting portion 10 and the first sealing portion 30.

As shown in FIG. 1, one principal surface of the photoelectric conversion element 20 may be in contact with the supporting portion 10, and the other principal surface and a side of the photoelectric conversion element 20 may be covered by the first sealing portion 30.

The exterior body 1 may consist of the supporting portion 10 and the first sealing portion 30.

An oxygen concentration in the first sealing portion 30 may be 10 ppm or more and 3000 ppm or less, or 100 ppm or more and 3000 ppm or less. In this case, photo degradation and thermal degradation phenomena induced by a defect of the photoelectric conversion material are reduced, and the durability of the solar cell can be further enhanced.

A ratio of a volume of the first sealing portion 30 to a volume of the exterior body 1 may be 0.0001% or more and less than 100%, or 0.001% or more and 10% or less.

FIG. 2 is a cross-sectional view schematically showing the second configuration example of the solar cell of the first embodiment.

A solar cell 110 shown in FIG. 2 is different from the solar cell 100 in that the first sealing portion 30 includes: a first layer 30a in contact with the surface of the photoelectric conversion element 20; and a second layer 30b disposed on the first layer 30a.

As shown in FIG. 2, the first sealing portion 30 may include the first layer 30a in contact with the surface of the photoelectric conversion element 20 and the second layer 30b disposed on the first layer 30a. The second layer 30b may be out of contact with the photoelectric conversion element 20.

The first sealing portion 30 may be composed of two or more layers. In this case, the oxygen diffusion rate in the first sealing portion 30 or the oxygen permeation rate of the first sealing portion 30 can be adjusted. Hence, the oxygen concentration in the region in contact with the photoelectric conversion element 20 is easily adjusted within the low concentration range suitable for perovskite solar cells. For example, the first sealing portion 30 may include two or more layers made of different materials. In this case, adherence between the supporting portion 10 and the first sealing portion 30 of the exterior body 1 can be enhanced.

In the solar cell of the first embodiment, when the first sealing portion 30 covers at least a portion of the surface of the photoelectric conversion element 20 supported by the supporting portion 10 composing the second sealing portion, as in the solar cell 100 of the first configuration example and the solar cell 110 of the second configuration example, a thickness of the first sealing portion 30 may be 0.6 µm or more and 15000 µm or less, or 20 µm or more and 10000 µm or less. It should be noted that the thickness of the first sealing portion 30 is the minimum of a distance between the first exposed surface 31 and the second exposed surface 32 of the first sealing portion 30.

When the thickness of the first sealing portion 30 is 0.6 µm or more and 15000 µm or less, the oxygen permeability coefficient of the first sealing portion 30 may be 3.1 × 10⁻¹⁸ cm³·cm/(cm²·s·cmHg) or more and 1.86 × 10⁻⁹ cm³·cm/(cm²·s·cmHg) or less.

When the thickness of the first sealing portion 30 is 20 µm or more and 10000 µm or less, the oxygen permeability coefficient of the first sealing portion 30 may be 3.1 × 10⁻¹⁷ cm³·cm/(cm²·s·cmHg) or more and 1.0 × 10⁻⁹ cm³·cm/(cm²·s·cmHg) or less.

The oxygen permeability coefficient of the first sealing portion 30 can be measured by a method described in Japanese Industrial Standards (JIS K-7126).

Each of the components of the solar cell of the present disclosure will be described hereinafter in details.

### (Exterior body 1)

The exterior body 1 surrounds the entire photoelectric conversion element 20. The exterior body 1 includes the first sealing portion 30. The exterior body 1 may further include the supporting portion 10 supporting the photoelectric conversion element 20. The exterior body 1 may include the second sealing portion.

### (First sealing portion 30)

The first sealing portion 30 includes the oxygen concentration adjusting material. The first sealing portion 30 has the first exposed surface 31 exposed to the outside of the exterior body 1 and the second exposed surface 32 exposed to the inside of the exterior body 1, and is continuous between the first exposed surface 31 and the second exposed surface 32. Therefore, oxygen can go in and out of the exterior body 1 through the first sealing portion 30. Hence, the oxygen concentration in the region in contact with the photoelectric conversion element 20 surrounded by the exterior body 1 can be adjusted within the low concentration range suitable for perovskite solar cells.

The oxygen concentration adjusting material is a material that can be permeable to oxygen. The oxygen concentration adjusting material has, for example, a relatively high oxygen permeability coefficient. A material that can be permeable to oxygen can be used as the oxygen concentration adjusting material. For example, a material having an oxygen permeability coefficient of 3.1 × 10⁻¹⁸ cm³·cm/(cm²·s·cmHg) or more and 1.86 × 10⁻⁹ cm³·cm/(cm²·s·cmHg) or less can be used. The oxygen permeability of the first sealing portion 30 can be adjusted in a desirable range, for example, by adjusting the shape of the first sealing portion 30, the volume ratio of the first sealing portion 30 to the exterior body, etc. according to the oxygen permeability coefficient of the material used.

The oxygen concentration adjusting material may include at least one selected from the group consisting of an inorganic material and an organic material. In the present disclosure, the organic material includes an organic-inorganic hybrid material such as a porous coordination polymer.

The inorganic material may be an oxide.

The oxygen permeability coefficients of oxides and organic materials vary in a relatively wide range. Therefore, the oxygen concentration in the region in contact with the photoelectric conversion element 20 is easily adjusted within the low concentration range suitable for perovskite solar cells. The relatively wide range of the oxygen permeability coefficients is, for example, 3.1 × 10⁻¹⁸ cm³·cm/(cm²·s·cmHg) or more and 1.86 × 10⁻⁹ cm³·cm/(cm²·s·cmHg) or less.

The inorganic material may be at least one selected from the group consisting of silicon nitride, silicon oxynitride, aluminum oxide, zirconium oxide, silicon oxide, cerium oxide, calcium oxide, iron oxide, zeolite, a porous silica, a porous carbon, a porous ceramic, and a metal. Among these, silicon nitride, silicon oxynitride, aluminum oxide, zirconium oxide, and silicon oxide have relatively high oxygen permeability coefficients for their defects or vacancies. The oxygen permeability coefficients of silicon nitride, silicon oxynitride, aluminum oxide, zirconium oxide, and silicon oxide are, for example, 9.1 × 10⁻¹⁵ cm³·cm/(cm²·s·cmHg) or more and 8.3 × 10⁻¹⁰ cm³·cm/(cm²·s·cmHg) or less.

Meanwhile, since having an oxygen adsorption ability, cerium oxide, calcium oxide, iron oxide, zeolite, a porous silica, a porous carbon, a porous ceramic, and a metal can adjust the oxygen permeability coefficient in combination with a resin having a different oxygen permeability coefficient.

The organic material may include at least one selected from the group consisting of formamidinium iodide, formamidinium bromide, formamidinium chloride, ethylammonium iodide, ethylammonium bromide, a carboxylic acid compound, a phosphoric acid compound, a silicic acid compound, a porous coordination polymer, a crown ether, a cyclodextrin, and a resin. Among these, formamidinium iodide, formamidinium bromide, formamidinium chloride, ethylammonium iodide, ethylammonium bromide, a carboxylic acid compound, a phosphoric acid compound, and a silicic acid compound have relatively high oxygen permeability coefficients. The relatively high oxygen permeability coefficients are, for example, 9.1 × 10⁻¹⁵ cm³·cm/(cm²·s·cmHg) or more and 8.3 × 10⁻¹⁰ cm³·cm/(cm²·s·cmHg) or less.

Meanwhile, since having an oxygen adsorption ability, a porous coordination polymer, a crown ether, and a cyclodextrin can adjust the oxygen permeability coefficient to be relatively high with a combination of a resin having a high oxygen permeability coefficient. The organic material may include a resin and at least one selected from the group consisting of a porous coordination polymer, a crown ether, and a cyclodextrin. The resin may be a resin having a high oxygen permeability coefficient.

Examples of the resin having a high oxygen permeability coefficient include ethyl cellulose, silicone rubber, polybutadiene, and natural rubber. The resin having a high oxygen permeability coefficient may have an oxygen permeability coefficient higher than 1.91 × 10⁻⁹ cm³·cm/(cm²·s·cmHg).

The oxygen concentration adjusting material may have an order of magnitude higher oxygen permeability coefficient than that of the material of the second sealing portion, or may have two orders of magnitude higher oxygen permeability coefficient than that of the material of the second sealing portion. The oxygen permeability coefficient of the oxygen concentration adjusting material can be measured by a method described in Japanese Industrial Standards (JIS K-7126 and K-7129), for example, using an atmospheric pressure ionization mass spectrometer, a gas chromatograph, an IR sensor, a coulometric sensor, an oxygen meter, or the like. The measurement apparatus and the measurement method need to be selected according to the value of the oxygen permeability coefficient.

The oxygen concentration adjusting material may have an oxygen permeability coefficient of 9.1 × 10⁻¹⁵ cm³·cm/(cm²·s·cmHg) or more. Examples of the material having such an oxygen permeability coefficient include a low-density oxide, a low-molecular-weight organic material, a resin having a high oxygen permeability coefficient, and a composite material thereof. The oxygen concentration adjusting material may have an oxygen permeability coefficient less than 8.34 × 10⁻¹⁰ cm³·cm/(cm²·s·cmHg). The oxygen concentration adjusting material may have an oxygen permeability coefficient of 9.1 × 10⁻¹⁵ cm³·cm/(cm²·s·cmHg) or more and less than 8.34 × 10⁻¹⁰ cm³·cm/(cm²·s·cmHg). The oxygen concentration adjusting material may have an oxygen permeability coefficient of 9.1 × 10⁻¹⁵ cm³·cm/(cm²·s·cmHg) or more and 8.3 × 10⁻¹⁰ cm³·cm/(cm²·s·cmHg) or less.

The low-density oxide can be formed, for example, by application, chemical vapor deposition, sputtering, or the like of oxide nanoparticles. Examples of the oxide include insulators made of aluminum oxide, zirconium oxide, and silicon oxide.

Examples of the low-molecular-weight organic material include formamidinium iodide, which is a solute of a solution applied to form a later-described photoelectric conversion layer 25 by application. The solute of the solution applied to form the photoelectric conversion layer 25 does not cause a degradation phenomenon such as corrosion between the first sealing portion 30 and the photoelectric conversion layer 25.

The amount of the oxygen concentration adjusting material in the first sealing portion 30 may be adjusted as appropriate so that the oxygen concentration in the region in contact with the photoelectric conversion element 20 will be within the low concentration range suitable for perovskite solar cells.

The first sealing portion 30 may include the oxygen concentration adjusting material as its main component. That is, the oxygen concentration adjusting material may account for 50% or more (50 mass% or more) of the whole first sealing portion 30 in terms of mass.

The oxygen concentration adjusting material may account for 70% or more (70 mass% or more) of the whole first sealing portion 30 in terms of mass.

The oxygen concentration adjusting material may account for 90% or more (90 mass% or more) of the whole first sealing portion 30 in terms of mass.

The first sealing portion 30 may consist of the oxygen concentration adjusting material.

The size of the first sealing portion 30 may be adjusted so that the oxygen concentration in the region in contact with the photoelectric conversion element 20 will not excessively increase.

The oxygen concentration in the first sealing portion 30 may be 10 ppm or more and 3000 ppm or less. In this case, the oxygen concentration in the region in contact with the photoelectric conversion element 20 can be 10 ppm or more and 3000 ppm or less. Therefore, the reaction product of the perovskite compound and oxygen or the decomposition product of the perovskite can be stably present on a surface of the perovskite or at a grain boundary therein. As a result, the products do not prevent carriers from transferring, and thus defect-induced photo degradation is reduced. Consequently, the durability of the solar cell can be enhanced.

The oxygen concentration in the first sealing portion 30 can be measured by time-of-flight secondary ion mass spectrometry (TOF-SIMS), thermal desorption spectroscopy (TDS), or the like. That is, when the photoelectric conversion element 20 and the first sealing portion 30 are in contact with each other, the oxygen concentration in the region in contact with the photoelectric conversion element 20 can be measured by measuring the oxygen concentration in the first sealing portion 30 by the above method.

The oxygen concentration in the first sealing portion 30 may be 100 ppm or more and 3000 ppm or less. In this case, the oxygen concentration in the region in contact with the photoelectric conversion element 20 can be 100 ppm or more and 3000 ppm or less. As a result, a defect of the photoelectric conversion material can be sufficiently terminated, and a heat-induced structural change of the photoelectric conversion material is less likely to happen. Therefore, a thermal degradation phenomenon induced by a defect of the photoelectric conversion material is also reduced, and the durability of the solar cell can be further enhanced.

The first sealing portion 30 may include an oxygen absorbent or an oxygen getter to decrease the oxygen diffusion rate in the first sealing portion 30.

The shape, the dimensions, the thickness, and the position of the first sealing portion 30, the material and the amount of the oxygen concentration adjusting material, and the like may be adjusted as appropriate so that the oxygen concentration in the region in contact with the photoelectric conversion element will be within the low concentration range suitable for perovskite solar cells during a period of actual operation of the solar cell. For example, the amount of the oxygen concentration adjusting material and the shape, the dimensions, the thickness, and the position of the first sealing portion 30 are designed according to the oxygen permeability coefficient of the material of the oxygen concentration adjusting material and an operation environment of the solar cell.

The first sealing portion 30 may be formed of a filler including the oxygen concentration adjusting material. Examples of such an oxygen concentration adjusting material include oxygen scavengers such as cerium oxide, calcium oxide, iron oxide, and an iron-based oxygen adsorbent, inorganic porous materials such as zeolite, a porous carbon, a porous silica, and a porous ceramic (such as alumina gel), and organic materials such as a porous coordination polymer (i.e., a metal-organic framework), a crown ether, and a cyclodextrin.

Examples of the filler include resin materials such as an ethylene-vinyl acetate copolymer resin, a silicon resin, a polyvinyl butyral resin, a polyolefin resin, an ionomer resin, and a polyimide resin.

### (Second sealing portion)

The second sealing portion includes a material having an oxygen permeability coefficient lower than that of the oxygen concentration adjusting material included in the first sealing portion 30. The second sealing portion has, for example, a gas barrier property. The term "gas barrier property" herein means a barrier property chiefly to oxygen, and having a gas barrier property indicates having a sufficiently low oxygen permeability coefficient. For example, the oxygen permeability coefficient is 3.05 × 10⁻¹⁸ cm³·cm/(cm²·s·cmHg) or less, and more preferably 3.05 × 10⁻¹⁹ cm³·cm/(cm²·s·cmHg) or less. The second sealing portion may have a barrier property to another gas. The second sealing portion may include at least one selected from the group consisting of glass, a metal, a ceramic, a plastic, and a resin. The second sealing portion may include at least one selected from the group consisting of glass and a resin.

The supporting portion 10 included in the second sealing portion supports the photoelectric conversion element 20. The supporting portion 10 can be formed, for example, of a transparent material. The supporting portion 10 has, for example, a gas barrier property. For example, a glass substrate or a plastic substrate can be used as the supporting portion 10. The plastic substrate may be, for example, a plastic film. When the plastic film has a poor oxygen barrier property, a gas barrier layer having an oxygen permeability coefficient of 3.05 × 10⁻¹⁸ cm³·cm/(cm²·s·cmHg) or less may be formed on the plastic film. When a second electrode 27 being a part of the photoelectric conversion element 20 has a light-transmitting property, the material of the supporting portion 10 may be a material having no light-transmitting property. For example, a metal, a ceramic, or a resin material having a low light-transmitting property can be used as the material of the supporting portion 10.

### (Photoelectric conversion element 20)

The photoelectric conversion element 20 includes a first electrode, a photoelectric conversion layer, and a second electrode in this order. The photoelectric conversion layer includes a perovskite compound.

The photoelectric conversion element 20 may further include an electron transport layer between the first electrode and the photoelectric conversion layer. The photoelectric conversion element 20 may further include a hole transport layer between the photoelectric conversion layer and the second electrode. The photoelectric conversion element 20 may include the first electrode, the electron transport layer, the photoelectric conversion layer, the hole transport layer, and the second electrode in this order.

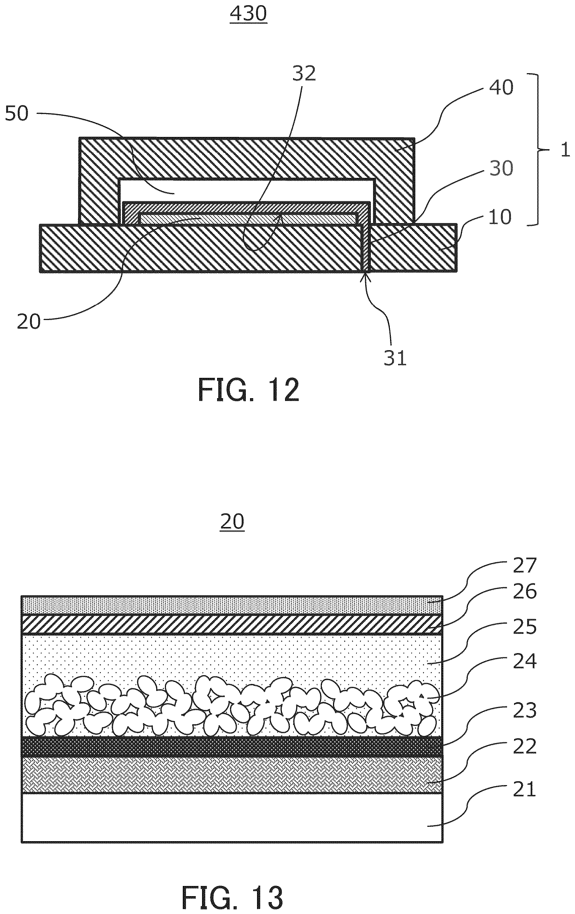

FIG. 13 is a cross-sectional view schematically showing an example of the photoelectric conversion element 20 of the solar cells according to the embodiments of the present disclosure.

The photoelectric conversion element 20 includes, for example, a substrate 21, a first electrode 22, an electron transport layer 23, a porous layer 24, a photoelectric conversion layer 25, a hole transport layer 26, and a second electrode 27 in this order.

Upon irradiation of the photoelectric conversion element 20 with light, the photoelectric conversion layer 25 absorbs the light to produce excited electrons and holes. The excited electrons transfer to the first electrode 22 through the electron transport layer 23. On the other hand, the holes formed in the photoelectric conversion layer 25 transfer to the second electrode 27 via the hole transport layer 26. The photoelectric conversion element 20 can thereby draw out an electric current from the first electrode 22 as a negative electrode and the second electrode 27 as a positive electrode.

The photoelectric conversion element 20 can be produced, for example, by the following method.

First, the first electrode 22 is formed on a surface of the substrate 21 by chemical vapor deposition, sputtering, or the like. Next, the electron transport layer 23 is formed by chemical vapor deposition, sputtering, solution application, or the like. Then, the porous layer 24 is formed by application, or the like. Subsequently, the photoelectric conversion layer 25 is formed. The photoelectric conversion layer 25 may be formed, for example, by solution application, printing, deposition, or the like. Alternatively, for example, a perovskite compound cut to a given thickness may be disposed as the photoelectric conversion layer 25 on the porous layer 24. Then, the hole transport layer 26 is formed on the photoelectric conversion layer 25 by chemical vapor deposition, sputtering, solution application, or the like. After that, the second electrode 27 is formed on the hole transport layer 26 by chemical vapor deposition, sputtering, solution application, or the like. The photoelectric conversion element 20 is obtained in this manner.

The components of the photoelectric conversion element 20 will be specifically described hereinafter.

### (Substrate 21)

The substrate 21 is an accessory component.

The substrate 21 supports the layers in the photoelectric conversion element 20.

The substrate 21 can be formed using a transparent material. A glass substrate or a plastic substrate, for example, can be used as the substrate 21. The plastic substrate may be, for example, a plastic film. When the second electrode 27 has a light-transmitting property, the material of the substrate 21 may be a material having no light-transmitting property. For example, a metal, a ceramic, or a resin material having a low light-transmitting property can be used as the material of the substrate 21.

When the first electrode 22 is strong enough to support the layers, the substrate 21 may be omitted. In this case, to facilitate sealing of the photoelectric conversion element 20, the first electrode 22 may be larger in size than the other layers of the photoelectric conversion element 20.

For the solar cell according to each embodiment of the present disclosure, the substrate 21 may be omitted when the photoelectric conversion element 20 is disposed on the supporting portion 10. That is, the supporting portion 10 may function as the substrate 21.

### (First electrode 22)

The first electrode 22 has electrical conductivity.

In the case where the photoelectric conversion element 20 is free of the electron transport layer 23, the first electrode 22 is made of a material that does not form an ohmic contact with the photoelectric conversion layer 25. Furthermore, the first electrode 22 has a property of blocking holes from the photoelectric conversion layer 25. The property of blocking holes from the photoelectric conversion layer 25 is a property of allowing only electrons formed in the photoelectric conversion layer 25 to pass therethrough and preventing holes from passing therethrough. The material having such a property is a material whose Fermi energy is higher than the energy at an upper part of the valence band of the photoelectric conversion layer 25. The material may be a material whose Fermi energy is higher than the Fermi energy of the photoelectric conversion layer 25. The material is specifically aluminum.

In the case where the photoelectric conversion element 20 includes the electron transport layer 23 between the first electrode 22 and the photoelectric conversion layer 25, the first electrode 22 does not necessarily have the property of blocking holes from the photoelectric conversion layer 25. That is, the material of the first electrode 22 may be a material that forms an ohmic contact with the photoelectric conversion layer 25.

The first electrode 22 has a light-transmitting property. For example, the first electrode 22 allows visible to near-infrared light to pass therethrough. The first electrode 22 is made of, for example, a material being transparent and having electrical conductivity. The first electrode 22 can be formed, for example, using a metal oxide and/or a metal nitride. Examples of the material include: titanium oxide doped with at least one selected from the group consisting of lithium, magnesium, niobium, and fluorine; gallium oxide doped with at least one selected from the group consisting of tin and silicon; gallium nitride doped with at least one selected from the group consisting of silicon and oxygen; tin oxide doped with at least one selected from the group consisting of antimony and fluorine; zinc oxide doped with at least one selected from the group consisting of boron, aluminum, gallium, and indium; indium-tin composite oxide; and their composites.

The first electrode 22 may be formed using a non-transparent material to have a pattern that allows light to pass therethrough. The pattern that allows light to pass therethrough is, for example, a linear pattern, a wave line pattern, a lattice pattern, or a perforated-metal-like pattern where a lot of small through holes are regularly or irregularly arranged. When the first electrode 22 has any of these patterns, light can pass through portions without the electrode material. Examples of the non-transparent electrode material include platinum, gold, silver, copper, aluminum, rhodium, indium, titanium, iron, nickel, tin, zinc, and an alloy including any of these. Alternatively, an electrically conductive carbon material can be used as the non-transparent electrode material.

The transmittance of the first electrode 22 may be, for example, 50% or more, or 80% or more. The wavelength of light that is to pass through the first electrode 22 depends on the absorption wavelength of the photoelectric conversion layer 25.

The thickness of the first electrode 22 may be 1 nm or more and 1000 nm or less.

### (Electron transport layer 23)

The electron transport layer 23 is disposed, for example, between the photoelectric conversion layer 25 and the first electrode 22. The electron transport layer 23 makes it possible to efficiently transfer electrons formed in the photoelectric conversion layer 25 to the first electrode 22. Consequently, an electric current can be efficiently drawn out, and thus the photoelectric conversion efficiency of the photoelectric conversion element 20 can be enhanced.

The electron transport layer 23 includes an electron transport material. The electron transport material is a material that transports an electron. The electron transport material can be a semiconductor. The electron transport layer 23 may be made of a semiconductor having a band gap of 3.0 eV or more. When the electron transport layer 23 is made of a semiconductor having a band gap of 3.0 eV or more, visible light and infrared light can pass therethrough and reach the photoelectric conversion layer 25.

### Examples of the electron transport material include inorganic n-type semiconductors.

For example, an oxide of a metal element, a nitride of a metal element, and a perovskite oxide can be used as the inorganic n-type semiconductor. For example, an oxide of Cd, Zn, In, Pb, Mo, W, Sb, Bi, Cu, Hg, Ti, Ag, Mn, Fe, V, Sn, Zr, Sr, Ga, Si, or Cr can be used as the oxide of a metal element. More specific examples of the oxide of a metal element include TiO₂ and SnO₂. The nitride of a metal element is, for example, GaN. The perovskite oxide is, for example, SrTiOs or CaTiOs.

The electron transport layer 23 may be made of a substance having a band gap more than 6.0 eV. Examples of the substance having a band gap of more than 6.0 eV include halides, such as lithium fluoride and calcium fluoride, of alkali metals and alkaline earth metals, alkali metal oxides such as magnesium oxide, and silicon dioxide. In this case, the thickness of the electron transport layer 23 may be, for example, 10 nm or less to secure the electron transport capability of the electron transport layer 23.

The electron transport layer 23 may include a plurality of layers made of different materials.

The photoelectric conversion element 20 may be free of the electron transport layer 23.

### (Porous layer 24)

The porous layer 24 is disposed, for example, between the electron transport layer 23 and the photoelectric conversion layer 25.

The porous layer 24 makes it easy to form the photoelectric conversion layer 25. The material of the photoelectric conversion layer 25 enters a pore of the porous layer 24, which thus serves as a foothold for the photoelectric conversion layer 25. This makes it unlikely that the material of the photoelectric conversion layer 25 is repelled by the surface of the porous layer 24 or aggregates on the surface of the porous layer 24. Consequently, the photoelectric conversion layer 25 can be easily formed as a uniform film.

The porous layer 24 can increase the optical path length of light passing through the photoelectric conversion layer 25 by causing light scattering. The amount of electrons and holes formed in the photoelectric conversion layer 25 is expected to increase with the increase of the optical path length.

The porous layer 24 is formed on the electron transport layer 23, for example, by application. In the case that the photoelectric conversion element 20 does not include the electron transport layer 23, the porous layer 24 is formed on the first electrode 22.

The porous layer 24 includes a porous body. The porous body includes a pore.

The porous body is made of, for example, continuous insulating particles or continuous semiconductor particles. The insulating particles are, for example, aluminum oxide particles or silicon oxide particles. The semiconductor particles are, for example, inorganic semiconductor particles. The inorganic semiconductor is, for example, a metal oxide, a perovskite oxide of a metal element, a metal sulfide, or a metal chalcogenide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. A more specific example of the metal oxide is TiO₂. The perovskite oxide of a metal element is, for example, SrTiOs or CaTiOs. The metal sulfide is, for example, CdS, ZnS, In₂S₃, PbS, Mo₂S, WS₂, Sb₂S₃, Bi₂S₃, ZnCdS₂, or Cu₂S. The metal chalcogenide is, for example, CsSe, In₂Se₃, WSe₂, HgS, PbSe, or CdTe.

The thickness of the porous layer 24 may be 0.01 µm or more and 10 µm or less, or 0.05 µm or more and 1 µm or less.

Regarding surface roughness of the porous layer 24, a surface roughness factor determined by dividing an effective area by a projected area may be 10 or greater, or 100 or greater. The projected area refers to the area of a shadow behind an object irradiated with light from the front. The effective area refers to the actual surface area of an object. The effective area can be calculated from a volume of an object, the specific surface area of the material of the object, and the bulk density of the material of the object, the volume being determined from the projected area and the thickness of the object. The specific surface area is measured, for example, by a nitrogen adsorption method.

The pore in the porous layer 24 is continuous from a portion of the porous layer 24 in contact with the photoelectric conversion layer 25 to a portion of the porous layer 24 in contact with the electron transport layer 23. That is, the pore of the porous layer 24 is continuous from one principal surface of the porous layer 24 to the other principal surface thereof. This allows the material of the photoelectric conversion layer 25 to fill the pore of the porous layer 24 and reach the surface of the electron transport layer 23. Therefore, even when the porous layer 24 is provided, the photoelectric conversion layer 25 and the electron transport layer 23 are in direct contact to each other and thus can exchange electrons therebetween.

### (Photoelectric conversion layer 25)

The photoelectric conversion layer 25 includes a perovskite compound.

The perovskite compound can be represented by a composition formula ABX₃. Here, A is a monovalent cation, B is a divalent cation, and X is a monovalent anion.

Examples of the monovalent cation A include an organic cation and an alkali metal cation.

Examples of the organic cation include a methylammonium cation (CH₃NH₃⁺), a formamidinium cation (HC(NH₂)₂⁺), an ethylammonium cation (CH₃CH₂NH₃⁺), and a guanidinium cation (CH₆N₃⁺).

Examples of the alkali metal cation include a potassium cation (K⁺), a cesium cation (Cs⁺), and a rubidium cation (Rb⁺).

Examples of the divalent cation B include a lead cation (Pb²⁺) and a tin cation (Sn²⁺).

Examples of the monovalent anion X include a halogen anion.

The sites of each of A, B, and X may be occupied by different ions.

The thickness of the photoelectric conversion layer 25 may be 50 nm or more and 10 µm or less.

The photoelectric conversion layer 25 can be formed by solution application, printing, deposition, or the like. The photoelectric conversion layer 25 may be formed by cutting the above perovskite compound and disposing the perovskite compound.

The photoelectric conversion layer 25 may include the perovskite compound represented by the composition formula ABX₃ as its main component. Saying that "the photoelectric conversion layer 25 includes a perovskite compound represented by the composition formula ABX₃ as its main component" means that the perovskite compound represented by the composition formula ABX₃ accounts for 90 mass% or more of the photoelectric conversion layer 25. The perovskite compound represented by the composition formula ABX₃ may account for 95 mass% or more of the photoelectric conversion layer 25. The photoelectric conversion layer 25 may consist of the perovskite compound represented by the composition formula ABX₃. The photoelectric conversion layer 25 needs to include the perovskite compound represented by the composition formula ABXs, and may include a defect or an impurity.

The photoelectric conversion layer 25 may include an additional compound different from the perovskite compound represented by the composition formula ABX₃. The additional compound is, for example, a compound having a Ruddlesden-Popper layered perovskite structure.

### (Hole transport layer 26)

The hole transport layer 26 is disposed, for example, between the photoelectric conversion layer 25 and the second electrode 27. The hole transport layer 26 makes it possible to efficiently transfer electrons formed in the photoelectric conversion layer 25 to the second electrode 27. Consequently, an electric current can be efficiently drawn out, and thus the photoelectric conversion efficiency of the photoelectric conversion element 20 can be enhanced.

The hole transport layer 26 includes a hole transport material. The hole transport material is a material that transports holes. The hole transport material can be an organic semiconductor or an inorganic semiconductor.

The hole transport layer 26 may include an organic semiconductor. The organic semiconductor forms a good interface between the organic semiconductor and the photoelectric conversion layer 25, and thus can reduce an increase of interfacial defects at the time of joining. Consequently, the photoelectric conversion efficiency and the durability of the solar cell can be enhanced.

Examples of a component of the organic semiconductor include triphenylamine, triallylamine, phenylbenzidine, phenylenevinylene, tetrathiafulvalene, vinylnaphthalene, vinylcarbazole, thiophene, aniline, pyrrole, carbazole, triptycene, fluorene, azulene, pyrene, pentacene, perylene, acridine, and phthalocyanine.

Typical examples of the organic semiconductor used as the hole transport material include 2,2',7,7'-tetrakis-(N,N-di-p-methoxyphenylamine)9,9'-spirobifluorene, poly[bis(4-phenyl)(2,4,6-trimethylphenyl)amine] (which may be hereinafter abbreviated as "PTAA"), poly(3-hexylthiophene-2,5-diyl), poly(3,4-ethylenedioxythiophene), and copper phthalocyanine.

The inorganic semiconductor used as the hole transport material is a p-type semiconductor. Examples of the inorganic semiconductor include Cu₂O, CuGaO₂, CuSCN, Cui, NiOₓ, MoOₓ, V₂O₅, and carbon materials such as graphene oxide. Here, x > 0 is established.

The hole transport layer 26 may include a plurality of layers made of different materials. For example, the plurality of layers whose ionization potentials are smaller than that of the photoelectric conversion layer 25 may be stacked such that the ionization potentials of the layers of the hole transport layer 26 decrease layer by layer. Hole transport properties of the hole transport layer 26 are improved thereby.

The thickness of the hole transport layer 26 may be 1 nm or more and 1000 nm or less, or 10 nm or more and 50 nm or less. In this case, sufficiently high hole transport properties can be exhibited and a low resistance of the solar cell can be maintained. Hence, highly efficient photovoltaic power generation can be achieved.

The hole transport layer 26 can be formed by application, printing, deposition, or the like. The same can be said to the photoelectric conversion layer 25. Examples of the application include doctor blade coating, bar coating, spraying, dip coating, and spin coating. Examples of the printing include screen printing. If needed, the hole transport layer 26 may be formed using a mixture of a plurality of materials and then compressed or fired. In the case that the material of the hole transport layer 26 is a low-molecular-weight organic substance or the inorganic semiconductor, the hole transport layer 26 can be produced by vacuum deposition.

The hole transport layer 26 may include, as an additive, at least one selected from the group consisting of a supporting electrolyte, a solvent, and a dopant. The supporting electrolyte and the solvent stabilize holes in the hole transport layer 26. The dopant increases the number of holes in the hole transport layer 26.

Examples of the supporting electrolyte include an ammonium salt, an alkaline earth metal salt, and a transition metal salt. Examples of the ammonium salt include tetrabutylammonium perchlorate, tetraethylammonium hexafluorophosphate, an imidazolium salt, and a pyridinium salt. Examples of the alkali metal salt include lithium perchlorate and potassium tetrafluoroborate. Examples of the alkaline earth metal salt include calcium(II) bis(trifluoromethanesulfonyl)imide. Examples of the transition metal salt include zinc(II) bis(trifluoromethanesulfonyl)imide and tris[4-tert-butyl-2-(1H-pyrazole-1-yl)pyridine]cobalt(III) tris(trifluoromethanesulfonyl).

Examples of the dopant include fluorine-containing aromatic boron compounds such as tris(pentafluorophenyl)borane.

The solvent included in the hole transport layer 26 may be excellent in ion conductivity. The solvent excellent in ion conductivity may be an aqueous solvent or an organic solvent. To make the solute more stable, the solvent included in the hole transport layer 26 may be an organic solvent. Specific examples of the organic solvent include heterocyclic compound solvents such as tert-butylpyridine, pyridine, and n-methylpyrrolidone.

An ionic liquid may be used alone as the solvent, or a mixture of an ionic liquid and another type of solvent may be used as the solvent. Ionic liquids are desirable for their low volatility and high flame retardancy.

Examples of the ionic liquid include imidazolium ionic liquids such as 1-ethyl-3-methylimidazolium tetracyano borate, pyridine ionic liquids, alicyclic amine ionic liquids, aliphatic amine ionic liquids, and azonium amine ionic liquids.

### (Second electrode 27)

The second electrode 27 has electrical conductivity.

In the case where the photoelectric conversion element 20 is free of the hole transport layer 26, the second electrode 27 is made of a material that does not form an ohmic contact with the photoelectric conversion layer 25. Furthermore, the second electrode 27 has a property of blocking electrons from the photoelectric conversion layer 25. The property of blocking electrons from the photoelectric conversion layer 25 refers to a property of allowing only holes formed in the photoelectric conversion layer 25 to pass therethrough and preventing electrons from passing therethrough. A material having such a property is a material whose Fermi energy is lower than the energy at a lower part of the conduction band of the photoelectric conversion layer 25. The material may be a material whose Fermi energy is lower than the Fermi energy of the photoelectric conversion layer 25. Specific examples thereof include platinum, gold, and carbon materials such as graphene.

In the case where the photoelectric conversion element 20 includes the hole transport layer 26, the second electrode 27 does not necessarily have the property of blocking electrons from the photoelectric conversion layer 25. That is, the material of the second electrode 27 may be a material that forms an ohmic contact with the photoelectric conversion layer 25. Therefore, the second electrode 27 can be formed to have a light-transmitting property.

Of the first electrode 22 or the second electrode 27, at least the electrode on which light is to be incident needs to have a light-transmitting property. That is, either the first electrode 22 or the second electrode 27 does not necessarily have a light-transmitting property. That is, either the first electrode 22 or the second electrode 27 does not necessarily include a material having a light-transmitting property, or does not necessarily have a pattern including an opening portion that allows light to pass therethrough.

### (Intermediate layer)

The photoelectric conversion element 20 may further include an intermediate layer. The intermediate layer is disposed, for example, between the electron transport layer 23 and the photoelectric conversion layer 25. When the photoelectric conversion element 20 includes the porous layer 24, the intermediate layer is disposed, for example, between the porous layer 24 and the photoelectric conversion layer 25.

The intermediate layer includes fullerene (C₆₀), a C₆₀ derivative, or a self-assembled monolayer having C₆₀ (hereinafter may be referred to as "C60SAM"). The intermediate layer may be made of a carboxylic acid compound, a phosphoric acid compound, or a silicic acid compound.

Since the intermediate layer efficiently collects electrons, a resistance loss during transportation of electrons to the electron transport layer 23 is decreased. The intermediate layer thus makes it possible to efficiently transfer electrons formed in the photoelectric conversion layer 25 to the electron transport layer 23 or the second electrode 27. Consequently, an electric current can be efficiently drawn out, and thus the photoelectric conversion efficiency of the photoelectric conversion element 20 can be enhanced.

Examples of the C₆₀ derivative include [6,6]-phenyl C₆₁ butyric acid methyl ester and [6,6]-phenyl-C₆₁ butyric acid butyl ester.

Examples of the C60SAM include 4-(1 ',5'-dihydro-1 '-methyl-2'H-[5,6]fullereno-C₆₀-lh-[1,9-c]pyrrol-2'-yl)benzoic acid, (1 ,2-methanofullerene C₆₀)-61-carboxylic acid, and C₆₀ pyrrolidine tris-acid.

The intermediate layer can be formed by solution application, immersion, printing, deposition, or the like.

The principal surface of the photoelectric conversion element 20 on the first electrode 22 side may face the supporting portion 10, or the principal surface of the photoelectric conversion element 20 on the second electrode 27 side may face the supporting portion.

### (Second embodiment)

A solar cell of a second embodiment will be described hereinafter. Descriptions of the features specified in the first embodiment may be omitted as appropriate.

In the solar cell of the second embodiment, the second sealing portion includes the supporting portion 10 supporting the photoelectric conversion element, and further includes a cover portion covering at least a portion of the surface of the photoelectric conversion element supported by the supporting portion 10.

Since the second sealing portion of the solar cell of the second embodiment includes the cover portion, the amount of oxygen that enters the inside, namely, the region in contact with the photoelectric conversion element 20, of the exterior body 1 through the first sealing portion 30 can be more easily controlled. Alternatively, since the second sealing portion includes the cover portion, a space having a given atmosphere can be disposed near the first sealing portion 30.

The exterior body may consist of the second sealing portion and the first sealing portion 30.

The first sealing portion 30 may be positioned between the supporting portion 10 and the cover portion.

The solar cell of the second embodiment will be hereinafter described in more details using first to fifth configuration examples. The solar cell of the second embodiment is not limited to solar cells of the first to fifth configuration examples given below.

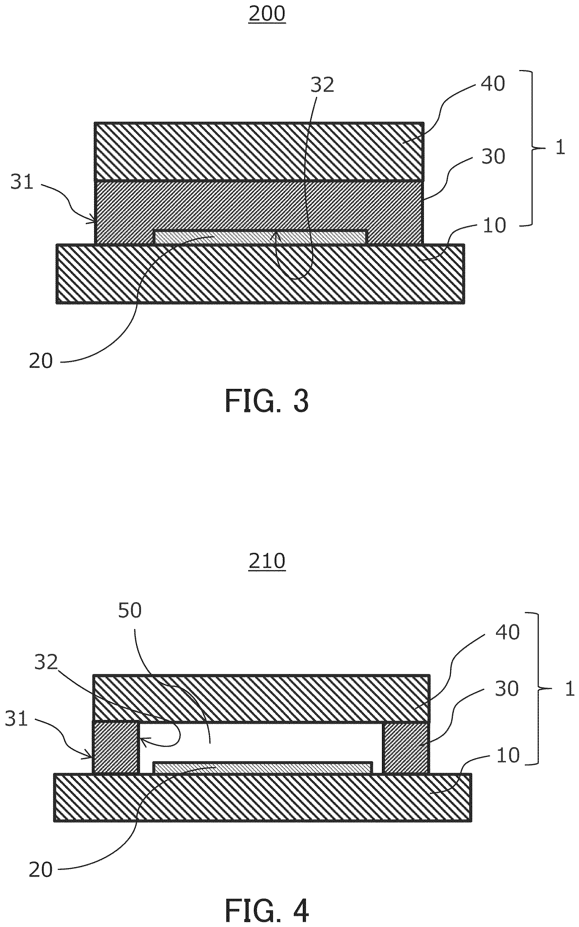

FIG. 3 is a cross-sectional view schematically showing the first configuration example of the solar cell of the second embodiment.

A solar cell 200 includes the photoelectric conversion element 20 and the exterior body 1. The exterior body 1 includes the supporting portion 10, the first sealing portion 30, and a cover portion 40 included in the second sealing portion. The first sealing portion 30 covers the surface of the photoelectric conversion element 20 supported by the supporting portion 10. The cover portion 40 included in the second sealing portion is provided on the first sealing portion 30. That is, in the solar cell 200 shown in FIG. 3, the cover portion 40 included in the second sealing portion is further provided on the first sealing portion 30 of the solar cell 100 of the first embodiment. The cover portion 40 included in the second sealing portion may be herein referred to as "cover portion 40". In the solar cell 200, the supporting portion 10 and the cover portion 40 compose the second sealing portion.

As shown in FIG. 3, the cover portion 40 may be disposed on one principal surface of the first sealing portion 30. The cover portion 40 may be in contact with the first sealing portion 30.

The cover portion 40 has, for example, a gas barrier property. A glass substrate or a plastic substrate, for example, can be used as the cover portion 40. The plastic substrate may be, for example, a plastic film. When the plastic film has a poor oxygen barrier property, a gas barrier layer having an oxygen permeability coefficient of 3.05 × 10⁻¹⁸ cm³·cm/(cm²·s·cmHg) or less may be formed on the plastic film. The cover portion 40 may include at least one selected from the group consisting of glass and a resin.

Glass has a low oxygen permeability coefficient. The resin included in the cover portion 40 may be a resin having a low oxygen permeability coefficient. Since the solar cell 200 includes the cover portion 40, oxygen goes through the first sealing portion 30 whose area in contact with external air is limited by the cover portion 40. This makes it easy to adjust the oxygen concentration in the region in contact with the photoelectric conversion element 20 within the low concentration range suitable for perovskite solar cells. The supporting portion 10 and the cover portion 40 may be made of the same material. The material may be glass.

While the first sealing portion 30 of the solar cell 200 shown in FIG. 3 covers the entire surface of the photoelectric conversion element 20 supported by the supporting portion 10, the first sealing portion 30 may cover at least a portion of the surface of the photoelectric conversion element 20 supported by the supporting portion 10.

The first sealing portion 30 may be in contact with the surface of the photoelectric conversion element 20.

The first sealing portion 30 may be provided to penetrate at least one selected from the group consisting of the supporting portion 10 and the cover portion 40 from the outside of the exterior body 1 toward the inside of the exterior body 1.

The solar cell of the second embodiment includes a first space surrounded by the exterior body 1. The photoelectric conversion element 20 may be positioned inside the first space.

The first space may be a sealed space.

FIG. 4 is a cross-sectional view schematically showing the second configuration example of the solar cell of the second embodiment.

A solar cell 210 includes the exterior body 1 and the photoelectric conversion element 20. The exterior body 1 includes the first sealing portion 30 and the second sealing portion, and the second sealing portion is composed of the supporting portion 10 and the cover portion 40. The first sealing portion 30 is in the shape of a frame. A first space 50 is defined by the supporting portion 10, the first sealing portion 30, and the cover portion 40. The photoelectric conversion element 20 is positioned in the first space 50.

The first sealing portion 30 may be out of contact with the photoelectric conversion element 20.

An oxygen concentration in the first space 50 may be 10 ppm or more and 3000 ppm or less, or 100 ppm or more and 3000 ppm or less.

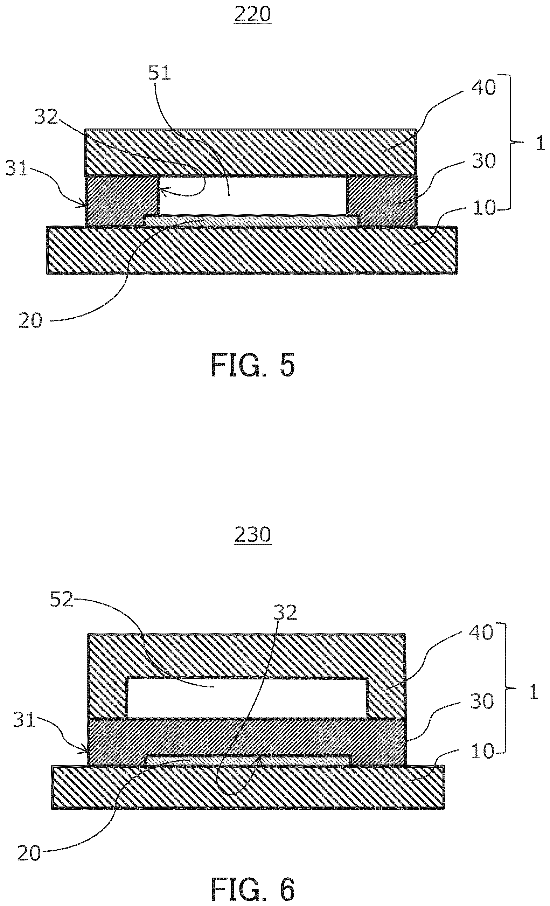

FIG. 5 is a cross-sectional view schematically showing the third configuration example of the solar cell of the second embodiment.

A solar cell 220 shown in FIG. 5 is different from the solar cell 210 in that the first sealing portion 30 covers a portion of the photoelectric conversion element 20.

As shown in FIG. 5, in the solar cell 220, a first space 51 may be defined by the photoelectric conversion element 20, the first sealing portion 30, and the cover portion 40.

An oxygen concentration in the first space 51 may be 10 ppm or more and 3000 ppm or less, or 100 ppm or more and 3000 ppm or less.

The solar cell of the second embodiment may have a second space different from the first space.

FIG. 6 is a cross-sectional view schematically showing the fourth configuration example of the solar cell of the second embodiment.

A solar cell 230 includes the exterior body 1 and the photoelectric conversion element 20. The exterior body 1 includes the first sealing portion 30 and the second sealing portion, and the second sealing portion is composed of the supporting portion 10 and the cover portion 40. A second space 52 is defined by the first sealing portion 30 and the cover portion 40. The first sealing portion 30 covers the surface of the photoelectric conversion element 20 supported by the supporting portion 10.

As shown in FIG. 6, the solar cell 230 may include the second space 52 defined by the first sealing portion 30 and the cover portion 40. The oxygen concentration in the region in contact with the photoelectric conversion element 20 can be controlled with high accuracy by adjusting an oxygen concentration in the second space 52.

As shown in FIG. 6, the solar cell of the second embodiment may be free of the first space and may include the second space only.

The solar cell of the second embodiment may include at least one selected from the group consisting of the first space and the second space.

The oxygen concentration in the second space 52 may be lower than that of external air. The oxygen concentration in the second space 52 may be, for example, less than 3000 ppm. In this case, an oxygen concentration in an vicinity of an interface between the photoelectric conversion element 20 and the first sealing portion 30 can be, for example, 10 ppm or more and 3000 ppm or less, or 100 ppm or more and 3000 ppm or less.

The first space and the second space may each be referred to as "space".

The oxygen concentration in the space of the solar cell can be measured using an atmospheric pressure ionization mass spectrometer, a gas chromatograph, an electrochemical oxygen meter, or the like. The oxygen concentration of a gas in the space of the solar cell can be measured, for example, by taking out the gas in the space using a syringe at room temperature (25°C), measuring components of the gas, and then calculating the proportion of oxygen therein or by breaking a solar cell module in a closed space at room temperature (25°C) to let the gas in the space flow out, measuring components of the gas, and then calculating the proportion of oxygen therein. Here, a method for letting the gas in the space of the solar cell flow into a closed space and then measuring the oxygen concentration in the gas flown out with an atmospheric pressure ionization mass spectrometer will be described as an example. For example, a solar cell module is placed in a chamber filled with an inert gas such as argon or krypton. The module is damaged in the chamber to let the gas in the space of the solar cell flow out. Next, quantitative analysis is performed for the gas in the chamber using an atmospheric pressure ionization mass spectrometer. Every component in the gas in the chamber is quantitated, and the proportion of the amount of oxygen in the total amount of the components is calculated. The oxygen concentration can thereby be determined. Examples of the gaseous components in the space except oxygen include inert gases such as nitrogen and noble gases, carbon dioxide, and water vapor. If the space contains an inert gas that is the same as the inert gas filling the chamber for the gas analysis, it may be difficult to analyze the gas in the space with accuracy. Therefore, in the case where the types of gaseous components in the space are unknown, the gas analysis is carried out for two identical solar cell modules by the above method using different inert gases as the inert gas filling the chamber. The composition of the gas in the space can be determined by comparing the analysis results for the two. The oxygen concentration in the region in contact with the photoelectric conversion element 20 can be determined by thus measuring the oxygen concentration in the space of the solar cell.

A portion of the cover portion 40 may be in contact with the supporting portion 10.

The cover portion 40 may be composed of two different layers.

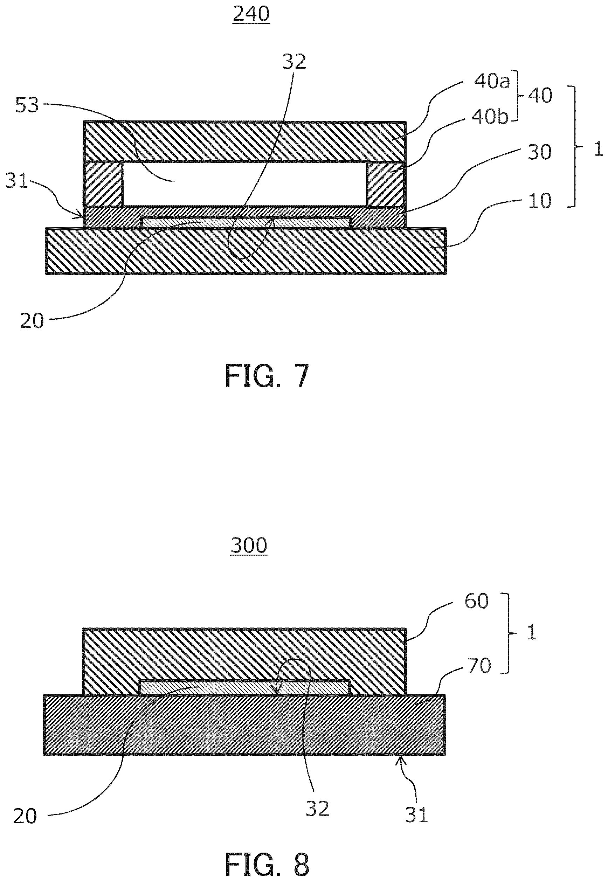

FIG. 7 is a cross-sectional view schematically showing the fifth configuration example of the solar cell of the second embodiment.

A solar cell 240 shown in FIG. 7 includes the exterior body 1 and the photoelectric conversion element 20. The exterior body 1 includes the first sealing portion 30 and the second sealing portion, and the second sealing portion is composed of the supporting portion 10 and the cover portion 40. The cover portion 40 includes a first portion 40a of the cover portion and a second portion 40b of the cover portion. A second space 53 is defined by the first sealing portion 30, the first portion 40a, and the second portion 40b. The first sealing portion 30 covers the surface of the photoelectric conversion element 20 supported by the supporting portion 10. That is, the solar cell 240 has a configuration that is based on the solar cell 230 and in which the cover portion 40 includes the first portion 40a and the second portion 40b.

As shown in FIG. 7, the first portion 40a may be disposed to face and be apart from the supporting portion 10. The first portion 40a may be a plate-shaped member.

As shown in FIG. 7, the second portion 40b may be disposed between the supporting portion 10 and the first portion 40a.

A portion of the second portion 40b may in contact with a periphery of the first sealing portion 30, and another portion of the second portion 40b may be in contact with a periphery of the first portion 40a, the other portion being opposite to the portion of the second portion 40b in contact with the periphery of the first sealing portion 30. In this case, the second space 53 can be defined by the first sealing portion 30, the first portion 40a, and the second portion 40b.

When the cover portion 40 included in the second sealing portion includes the first portion 40a and the second portion 40b, the first portion 40a may be disposed to face and be apart from the supporting portion 10, and the second portion 40b may be disposed between the supporting portion 10 and the first portion 40a.

In the case where the photoelectric conversion element 20 absorbs light incident thereon from the supporting portion 10 side and performs photoelectric conversion, the first portion 40a needs to have a gas barrier property equivalent to that of a glass substrate and does not need to have a light-transmitting property. In this case, examples of the first portion 40a include a metal plate, a glass substrate, a ceramic plate, or a plastic substrate. The plastic substrate may be, for example, a plastic film. When the plastic film has a poor oxygen barrier property, a gas barrier layer having an oxygen permeability coefficient of 3.05 × 10⁻¹⁸ cm³·cm/(cm²·s·cmHg) or less may be formed on the plastic film.

In the case where the photoelectric conversion element 20 absorbs light incident thereon from the side opposite to the supporting portion 10 side and performs photoelectric conversion, the first portion 40a may have a sunlight-transmitting property. In this case, examples of the first portion 40a include transparent substrates such as a glass substrate and a plastic substrate.

The second portion 40b may have a gas barrier property and high adhesiveness to both the supporting portion 10 and the first portion 40a.

Examples of the material of the second portion 40b include resin materials such as an epoxy resin, an acrylic resin, and an isoprene-isobutene copolymer resin.

The second portion 40b can prevent a gas in external air from entering the exterior body 1 during an actual operation period.

The second portion 40b of the cover portion may include a material having an oxygen permeability coefficient lower than that of the oxygen concentration adjusting material included in the first sealing portion 30.

When the first sealing portion 30 is disposed, as shown in FIGS. 3 to 7, between the supporting portion 10 and the cover portion 40 included in the second sealing portion, the thickness of the first sealing portion 30, namely, the minimum of the distance between the first exposed surface 31 and the second exposed surface 32 of the first sealing portion 30, may be 0.6 µm or more and 15000 µm or less, or 20 µm or more and 10000 µm or less. When the second space is defined by the first sealing portion 30 and the cover portion 40 as shown in FIGS. 6 and 7, the minimum of a distance between a surface of the first sealing portion 30 in contact with the second space and the second exposed surface 32 of the first sealing portion may be 0.001 µm or more and 15000 µm or less, or 0.01 µm or more and 10000 µm or less.

When the distance between the first exposed surface 31 and the second exposed surface 32 of the first sealing portion 30 is 0.6 µm or more and 15000 µm or less, the oxygen permeability coefficient of the first sealing portion 30 may be 3.1 × 10⁻¹⁸ cm³·cm/(cm²·s·cmHg) or more and 1.86 × 10⁻⁹ cm³·cm/(cm²·s·cmHg) or less.

When the distance between the first exposed surface 31 and the second exposed surface 32 of the first sealing portion 30 is 20 µm or more and 10000 µm or less, the oxygen permeability coefficient of the first sealing portion 30 may be 3.1 × 10⁻¹⁷ cm³·cm/(cm²·s·cmHg) or more and 1.0 × 10⁻⁹ cm³·cm/(cm²·s·cmHg) or less.

The first sealing portion 30 functions to adjust the oxygen concentration in the first space within the low concentration range suitable for perovskite solar cells, and can adjust the oxygen concentration in an appropriate range (for example, 10 ppm or more and 3000 ppm or less, or 100 ppm or more and 3000 ppm or less).

### (Third embodiment)

A solar cell of a third embodiment will be described hereinafter. Descriptions of the features specified in the first and second embodiments may be omitted as appropriate.

In the solar cell of the third embodiment, the first sealing portion is composed of the supporting portion supporting the photoelectric conversion element. The solar cell of the third embodiment will be hereinafter described in more details using a first configuration example. The solar cell of the third embodiment is not limited to a solar cell of the first configuration example given below.

FIG. 8 is a cross-sectional view schematically showing the first configuration example of the solar cell of the third embodiment. A solar cell 300 shown in FIG. 8 includes the photoelectric conversion element 20 and the exterior body 1. The exterior body 1 includes the first sealing portion and a second sealing portion 60. The first sealing portion is composed of a supporting portion 70 supporting the photoelectric conversion element 20. The second sealing portion covers the surface of the photoelectric conversion element 20 supported by the supporting portion 70 composing the first sealing portion. The supporting portion 70 composing the first sealing portion may be herein referred to as "supporting portion 70".

The first sealing portion has the first exposed surface 31 exposed to the outside of the exterior body 1 and the second exposed surface 32 exposed to the inside of the exterior body 1, and is continuous between the first exposed surface 31 and the second exposed surface 32. As for the solar cell 300, oxygen can go in and out of the exterior body 1 through the supporting portion 70.

As shown in FIG. 8, the second sealing portion 60 may cover at least a portion of the surface of the photoelectric conversion element 20 supported by the supporting portion 70. The second sealing portion 60 may cover the entire surface of the photoelectric conversion element 20 supported by the supporting portion 70.

The second sealing portion 60 may be in contact with the surface of the photoelectric conversion element 20.

As shown in FIG. 8, the photoelectric conversion element 20 may be sandwiched between the supporting portion 70 and the second sealing portion 60. The photoelectric conversion element 20 may be in contact with the supporting portion 70. The photoelectric conversion element 20 may be in contact with the supporting portion 70 and the second sealing portion 60.

As shown in FIG. 8, one principal surface of the photoelectric conversion element 20 may be in contact with the supporting portion 70, and the other principal surface and a side of the photoelectric conversion element 20 may be covered with the second sealing portion 60.

The exterior body 1 may consist of the supporting portion 70 composing the first sealing portion and the second sealing portion 60.

The second sealing portion 60 may be composed of two or more layers.

The supporting portion 70 composing the first sealing portion may be composed of two or more layers. In this case, the oxygen diffusion rate in the supporting portion 70 or the oxygen permeation rate of the supporting portion 70 can be adjusted. Therefore, the oxygen concentration in the region in contact with the photoelectric conversion element 20 is easily adjusted within the low concentration range suitable for perovskite solar cells. For example, the supporting portion 70 may include two or more layers made of different materials.

### (Fourth embodiment)

A solar cell of a fourth embodiment will be described hereinafter. Descriptions of the features specified in the first to third embodiments may be omitted as appropriate.

In the solar cell of the fourth embodiment, the first sealing portion 30 is provided to penetrate at least one selected from the group consisting of the supporting portion 10 and the cover portion 40 from the outside of the exterior body toward the inside of the exterior body. The solar cell of the fourth embodiment will be hereinafter described in more details using first to fourth configuration examples. The solar cell of the fourth embodiment is not limited to solar cell of the first to fourth configuration examples given below.

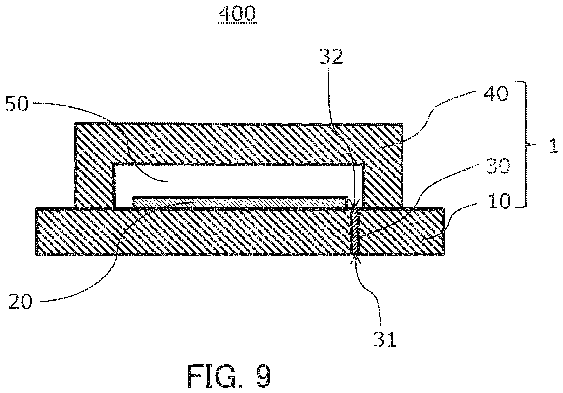

FIG. 9 is a cross-sectional view schematically showing the first configuration example of the solar cell of the second embodiment.

A solar cell 400 includes the photoelectric conversion element 20 and the exterior body 1. The exterior body 1 includes the first sealing portion 30 and the second sealing portion. The second sealing portion is composed of the supporting portion 10 and the cover portion 40 covering the photoelectric conversion element 20 supported by the supporting portion 10. In FIG. 9, the cover portion 40 is in contact with the supporting portion 10. The first space 50 is defined by the first sealing portion 30 and the second sealing portion. The first sealing portion 30 is in contact with and surrounded by the supporting portion 10, and is provided to penetrate the supporting portion 10 from the outside of the exterior body 1 toward the inside of the exterior body 1. That is, in the solar cell 400, the first sealing portion 30 is disposed to penetrate a portion of the supporting portion 10 from the outside of the exterior body 1 toward the inside of the exterior body 1.

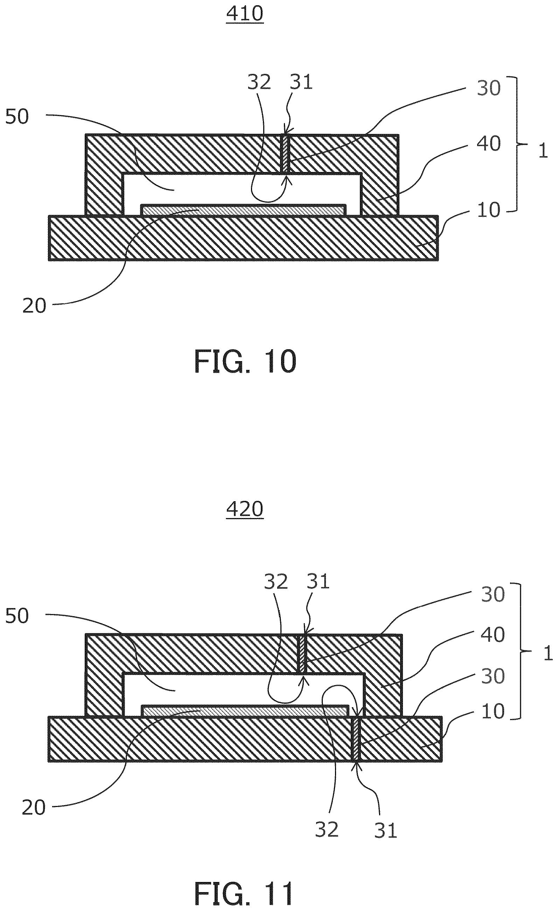

FIG. 10 is a cross-sectional view schematically showing the second configuration example of the solar cell of the fourth embodiment.

A solar cell 410 includes the photoelectric conversion element 20 and the exterior body 1. The exterior body 1 includes the first sealing portion 30 and the second sealing portion. The second sealing portion is composed of the supporting portion 10 and the cover portion 40 covering the photoelectric conversion element 20 supported by the supporting portion 10. In FIG. 10, the cover portion 40 is in contact with the supporting portion 10. The first space 50 is defined by the first sealing portion 30 and the second sealing portion. The first sealing portion 30 is in contact with and surrounded by the cover portion 40, and is provided to penetrate the cover portion 40 from the outside of the exterior body 1 toward the inside of the exterior body 1. That is, in the solar cell 410, the first sealing portion 30 is disposed to penetrate a portion of the cover portion 40 composing the second sealing portion from the outside of the exterior body 1 toward the inside of the exterior body 1.

FIG. 11 is a cross-sectional view schematically showing the third configuration example of the solar cell of the second embodiment.

A solar cell 420 includes the photoelectric conversion element 20 and the exterior body 1. The exterior body 1 includes the first sealing portion 30 and the second sealing portion. The second sealing portion is composed of the supporting portion 10 and the cover portion 40 covering the photoelectric conversion element 20 supported by the supporting portion 10. In FIG. 11, the cover portion 40 is in contact with the supporting portion 10. The first space 50 is defined by the first sealing portion 30 and the second sealing portion. The first sealing portion 30 includes two components: (1) one in contact with and surrounded by the supporting portion 10 and provided to penetrate the supporting portion 10 from the outside of the exterior body 1 toward the inside of the exterior body 1; and (2) one in contact with and surrounded by the cover portion 40 and provided to penetrate the cover portion 40 from the outside of the exterior body 1 toward the inside of the exterior body 1. That is, in the solar cell 420, the first sealing portion 30 is disposed to penetrate a portion of the supporting portion 10 and a portion of the cover portion 40 from the outside of the exterior body 1 toward the inside of the exterior body 1.

As shown in FIGS. 9 to 11, the first sealing portion 30 may be out of contact with the photoelectric conversion element 20.

The first sealing portion 30 may cover at least a portion of the surface of the photoelectric conversion element 20.

FIG. 12 is a cross-sectional view schematically showing the fourth configuration example of the solar cell of the fourth embodiment.

A solar cell 430 shown in FIG. 12 has a configuration that is based on the solar cell 400 and in which the surface of the photoelectric conversion element 20 supported by the supporting portion 10 is covered by the first sealing portion 30.

At least a portion of the surface of the photoelectric conversion element 20 supported by the supporting portion 10 may be covered by the first sealing portion 30.

The shape of the first sealing portion 30 provided to penetrate a portion of the exterior body 1 from the outside of the exterior body 1 toward the inside of the exterior body 1 is not limited to a particular shape.

When the first sealing portion 30 is positioned to penetrate the supporting portion 10, the shape of the first sealing portion 30, i.e., the shape of a through hole, may be circular or elliptical in plan view. When the shape is circular, the diameter of the through hole may be 100 µm or less.

The solar cells of the first to fourth embodiments each may further include at least one selected from the group consisting of a moisture getter material and a filler. At least one selected from the group consisting of the moisture getter material and the filler is provided between the exterior body 1 and the photoelectric conversion element 20.

The first spaces 50 and 51 and the second spaces 52 and 53 each may include at least one selected from the group consisting of a filler and one selected from the group consisting of a moisture getter material, a moisture adsorbing material, and a desiccating material. In this case, the durability of the solar cell can be enhanced.

The moisture getter material can prevent a sharp increase of the moisture concentration in the space, the sharp increase being attributable to deterioration of the second sealing portion, a damage to the solar cell, or the like. The moisture getter material therefore can maintain a low moisture concentration in the region in contact with the photoelectric conversion element 20 and enhance the durability of the solar cell.

The moisture getter material is preferably excellent in moisture adsorption ability and does not release adsorbed moisture into the space.

The filler can enhance the mechanical strength (especially, the shock resistance) of the solar cell.

Examples of the filler include resin materials such as an ethylene-vinyl acetate copolymer resin, a silicon resin, a polyvinyl butyral resin, a polyolefin resin, an ionomer resin, and a polyimide resin.

When the filler is in contact with the photoelectric conversion element 20, the filler may include an oxygen concentration adjusting material. In this case, the oxygen concentration at the interface between the filler and the photoelectric conversion element 20, namely in the region in contact with the photoelectric conversion element 20, can be within the low concentration range suitable for perovskite solar cells. The oxygen concentration in the region in contact with the photoelectric conversion element 20 may be 10 ppm or more and 3000 ppm or less, or 100 ppm or more and 3000 ppm or less.

The first spaces 50 and 51 and the second spaces 52 and 53 each may include an oxygen absorbent or an oxygen getter. By means of the oxygen absorbent or the oxygen getter, the oxygen concentration in the region in contact with the photoelectric conversion element may be adjusted within the low concentration range suitable for perovskite solar cells during a period of actual operation of the solar cell.

### [Other embodiments]

### (Supplement)

According to the descriptions of the above embodiments, the following techniques are disclosed.

### (Technique 1)

A solar cell including:
a photoelectric conversion element; and
an exterior body surrounding the entire photoelectric conversion element, wherein
the photoelectric conversion element includes a perovskite compound,
the exterior body includes a first sealing portion and a second sealing portion,
the first sealing portion includes an oxygen concentration adjusting material, has a first exposed surface exposed to an outside of the exterior body and a second exposed surface exposed to an inside of the exterior body, and is continuous between the first exposed surface and the second exposed surface, and
the second sealing portion includes a material having an oxygen permeability coefficient lower than that of the oxygen concentration adjusting material.

The solar cell configured as above can have enhanced durability.

### (Technique 2)

The solar cell according to Technique 1, wherein the exterior body consists of the first sealing portion and the second sealing portion.

The solar cell configured as above can have enhanced durability.

### (Technique 3)

The solar cell according to Technique 1 or 2, wherein the first sealing portion is composed of a supporting portion supporting the photoelectric conversion element.

The solar cell configured as above can have enhanced durability.

### (Technique 4)

The solar cell according to Technique 3, wherein the second sealing portion covers at least a portion of a surface of the photoelectric conversion element supported by the supporting portion.

The solar cell configured as above can have enhanced durability.

### (Technique 5)

The solar cell according to Technique 1 or 2, wherein the second sealing portion includes a supporting portion supporting the photoelectric conversion element.

The solar cell configured as above can have enhanced durability.

### (Technique 6)

The solar cell according to Technique 5, wherein the first sealing portion covers at least a portion of a surface of the photoelectric conversion element supported by the supporting portion.

The solar cell configured as above can have enhanced durability.

### (Technique 7)

The solar cell according to Technique 6, wherein the first sealing portion is in contact with the surface of the photoelectric conversion element.

The solar cell configured as above can have enhanced durability.

### (Technique 8)

The solar cell according to Technique 7, wherein the first sealing portion includes: a first layer in contact with the surface of the photoelectric conversion element; and a second layer disposed on the first layer.

The solar cell configured as above can have enhanced durability.

### (Technique 9)

The solar cell according to any one of Techniques 5 to 8, wherein the second sealing portion further includes a cover portion covering at least a portion of a surface of the photoelectric conversion element supported by the supporting portion.

The solar cell configured as above can have further enhanced durability.

### (Technique 10)

The solar cell according to Technique 9, wherein the first sealing portion is positioned between the supporting portion and the cover portion.

The solar cell configured as above can have enhanced durability.

### (Technique 11)

The solar cell according to Technique 9 or 10, wherein the first sealing portion is out of contact with the photoelectric conversion element.

The solar cell configured as above can have enhanced durability.

### (Technique 12)

The solar cell according to any one of Techniques 9 to 11, wherein the first sealing portion is provided to penetrate at least one selected from the group consisting of the supporting portion and the cover portion from the outside of the exterior body toward the inside of the exterior body.

The solar cell configured as above can have enhanced durability.

### (Technique 13)

The solar cell according to any one of Techniques 1 to 12, including a first space surrounded by the exterior body, wherein
the photoelectric conversion element is positioned inside the first space.

The solar cell configured as above can have enhanced durability.

### (Technique 14)

The solar cell according to any one of Techniques 1 to 13, wherein the oxygen concentration adjusting material includes at least one selected from the group consisting of an inorganic material and an organic material.

The solar cell configured as above can have enhanced durability.

### (Technique 15)

The solar cell according to Technique 14, wherein the inorganic material is at least one selected from the group consisting of silicon nitride, silicon oxynitride, aluminum oxide, zirconium oxide, silicon oxide, cerium oxide, calcium oxide, iron oxide, zeolite, a porous silica, a porous carbon, a porous ceramic, and a metal.

The solar cell configured as above can have enhanced durability.

### (Technique 16)

The solar cell according to Technique 14, wherein the organic material is at least one selected from the group consisting of formamidinium iodide, formamidinium bromide, formamidinium chloride, ethylammonium iodide, ethylammonium bromide, a carboxylic acid compound, a phosphoric acid compound, a silicic acid compound, a porous coordination polymer, a crown ether, a cyclodextrin, and a resin.

The solar cell configured as above can have enhanced durability.

### (Technique 17)

The solar cell according to any one of Techniques 1 to 16, wherein the second sealing portion includes at least one selected from the group consisting of glass and a resin.

The solar cell configured as above can have enhanced durability.

### (Technique 18)

The solar cell according to any one of Techniques 1 to 17, wherein the photoelectric conversion element includes a first electrode, a photoelectric conversion layer, and a second electrode in this order.

The solar cell configured as above can have enhanced durability.

### (Technique 19)

The solar cell according to any one of Techniques 1 to 18, further including at least one selected from the group consisting of a moisture getter material and a filler, wherein
at least one selected from the group consisting of the moisture getter material and the filler is provided between the exterior body and the photoelectric conversion element.

The solar cell configured as above can have enhanced durability.

### (Technique 20)

The solar cell according to any one of Techniques 1 to 19, wherein an oxygen concentration in a region in contact with the photoelectric conversion element is 100 ppm or more and 3000 ppm or less.

The solar cell configured as above can have further enhanced durability.

### (Technique 21)

The solar cell according to Technique 20, wherein an oxygen concentration in the first sealing portion is 100 ppm or more and 3000 ppm or less.

The solar cell configured as above can have further enhanced durability.

### (Technique 22)

The solar cell according to Technique 20 or 21, including a first space surrounded by the exterior body, wherein
the photoelectric conversion element is positioned inside the first space, and
an oxygen concentration in the first space is 100 ppm or more and 3000 ppm or less.

The solar cell configured as above can have further enhanced durability.

### EXAMPLES

The present disclosure will be described hereinafter in more details with reference to Examples and Comparative Example.

Perovskite solar cells were produced in Examples and Comparative Example, and initial properties of the solar cells and properties thereof after a light resistance test and a thermal resistance test were evaluated.

The configurations of photoelectric conversion elements of the solar cells of Examples 1 and 2 and Comparative Example 1 are as follows.
- Substrate: a glass substrate (thickness: 0.7 mm)
- First electrode: a transparent electrode (indium-tin composite oxide layer) (thickness: 200 nm)
- Electron transport layer: titanium oxide (TiO₂) (thickness: 10 nm)
- Porous layer: titanium oxide (TiO₂) having a mesoporous structure
- Photoelectric conversion layer: a layer including HC(NH₂)₂PbI₃ as its main component (thickness: 500 nm)
- Hole transport layer: a layer including n-butylammoniumbromide (manufactured by GreatCell Solar Limited) and a layer including PTAA as its main component (and tris(pentafluorophenyl)borane (manufactured by Tokyo Chemical Industry Co., Ltd.) as an additive) (thickness: 50 nm)
- Second electrode: Au (thickness: 200 nm)

### <Production of photoelectric conversion element>

First, a glass substrate having a thickness of 0.7 mm was prepared as a substrate. The substrate functions also as the supporting portion (the supporting portion 10 included in the second sealing portion) of the solar cell of the present disclosure.

An indium-tin composite oxide layer was formed on the substrate by sputtering. A first electrode was formed in this manner.

Next, a titanium oxide layer was formed on the first electrode by sputtering. An electron transport layer was formed in this manner.

Then, a layer of titanium oxide having a mesoporous structure was formed on the electron transport layer. Specifically, 30NR-D (manufactured by GreatCell Solar Limited) was applied by spin coating, followed by firing at 500°C for 30 minutes. A porous layer was formed in this manner.

Next, a raw material solution containing a photoelectric conversion material was applied to the porous layer by spin coating to form a photoelectric conversion layer including a perovskite compound. The raw material solution contained 0.92 mol/L lead(II) iodide (manufactured by Tokyo Chemical Industry Co., Ltd.), 0.17 mol/L lead(II) bromide (manufactured by Tokyo Chemical Industry Co., Ltd.), 0.83 mol/L formamidinium iodide (manufactured by GreatCell Solar Limited), 0.17 mol/L methylammonium bromide (manufactured by GreatCell Solar Limited), 0.05 mol/L cesium iodide (manufactured by Iwatani Corporation), and 0.05 mol/L rubidium iodide (manufactured by Iwatani Corporation). The solvent of the raw material solution was a solvent mixture containing dimethyl sulfoxide (DMSO) (Acros Organics) and N,N-dimethylformamide (DMF) (Acres Organics) at a volume ratio of DMSO: DMF = 1:4.

Next, a solution containing 6.49 × 10⁻³ mol/L n-butylammoniumbromide was applied to the photoelectric conversion layer by spin coating. The solvent was 2-propanol. Next, a raw material solution containing a hole transport material was applied by spin coating to form a hole transport layer. The solvent of the raw material solution was toluene (Acros Organics), and the solution contained 10 g/L PTAA.

Subsequently, an Au film was deposited on the hole transport layer by vacuum deposition to form a second electrode.

A photoelectric conversion element for each of the solar cells of Examples 1 and 2 and Comparative Example 1 were formed in this manner on the glass substrate being a supporting portion.

The configurations of photoelectric conversion elements of the solar cells of Example 3 and Example 4 are as follows. The photoelectric conversion elements of the solar cells of Examples 3 and 4 each include an intermediate layer.
- Substrate: a glass substrate (thickness: 0.7 mm)
- First electrode: a transparent electrode (indium-tin composite oxide layer) (thickness: 200 nm)
- Electron transport layer: titanium oxide (TiO₂) (thickness: 10 nm)
- Porous layer: titanium oxide (TiO₂) having a mesoporous structure
- Intermediate layer: 4-(1',5'-dihydro-1'-methyl-2'H-[5,6]fullereno-C₆₀-lh-[1,9-c]pyrrol-2'-yl)benzoic acid (manufactured by Sigma-Aldrich Co., LLC.)
- Photoelectric conversion layer: a layer including HC(NH₂)₂PbI₃ as its main component (thickness: 500 nm)
- Hole transport layer: a layer including n-butylammoniumbromide (manufactured by GreatCell Solar Limited) and a layer including PTAA as its main component (and tris(pentafluorophenyl)borane (manufactured by Tokyo Chemical Industry Co., Ltd.) as an additive) (thickness: 50 nm)
- Second electrode: Au (thickness: 200 nm)

### <Production of photoelectric conversion element>

First, a glass substrate having a thickness of 0.7 mm was prepared. The substrate functions also as the supporting portion of the solar cell of the present disclosure.

An indium-tin composite oxide layer was formed on the substrate by sputtering. A first electrode was formed in this manner.

Next, a titanium oxide layer was formed on the first electrode by sputtering. An electron transport layer was formed in this manner.

Then, a layer of titanium oxide having a mesoporous structure was formed on the electron transport layer. Specifically, 30NR-D (manufactured by GreatCell Solar Limited) was applied by spin coating, followed by firing at 500°C for 30 minutes. A porous layer was formed in this manner.

Next, the substrate with the porous layer at the top was immersed in a C60SAM solution for 30 minutes, and then taken out. The C60SAM solution was obtained by adding C60SAM to a solution mixture so that the C60SAM concentration would be 1 × 10⁻⁵ mol/L, the solution mixture containing tetrahydrofuran (manufactured by FUJIFILM Wako Pure Chemical Corporation) and ethanol (manufactured by FUJIFILM Wako Pure Chemical Corporation) at a volume ratio of 1:1. The substrate taken out of the solution was sufficiently rinsed in an ethanol solution, and then annealed at 100°C for 30 minutes using a hot plate. By natural cooling to room temperature after the annealing, the porous layer was modified with C60SAM. An intermediate layer was formed in this manner.

Next, a raw material solution containing a photoelectric conversion material was applied to the porous layer by spin coating to form a photoelectric conversion layer including a perovskite compound. The raw material solution contained 0.92 mol/L lead(II) iodide (manufactured by Tokyo Chemical Industry Co., Ltd.), 0.17 mol/L lead(II) bromide (manufactured by Tokyo Chemical Industry Co., Ltd.), 0.83 mol/L formamidinium iodide (manufactured by GreatCell Solar Limited), 0.17 mol/L methylammonium bromide (manufactured by GreatCell Solar Limited), 0.05 mol/L cesium iodide (manufactured by Iwatani Corporation), and 0.05 mol/L rubidium iodide (manufactured by Iwatani Corporation). The solvent of the raw material solution was a solvent mixture containing DMSO (Acres Organics) and DMF (Acres Organics) at a volume ratio of DMSO:DMF = 1:4.

Next, a solution containing 6.49 × 10⁻³ mol/L n-butylammoniumbromide was applied to the photoelectric conversion layer by spin coating. The solvent was 2-propanol. Next, a raw material solution containing a hole transport material was applied by spin coating to form a hole transport layer. The solvent of the raw material solution was toluene (Acros Organics), and the solution contained 10 g/L PTAA.

Subsequently, an Au film was deposited on the hole transport layer by vacuum deposition to form a second electrode.

A photoelectric conversion element for each of the solar cells of Example 3 and Example 4 were formed in this manner on the glass substrate being a supporting portion.

### <Production of solar cell>

### (Example 1)

In Example 1, a raw material solution containing an oxygen concentration adjusting material was applied to the second electrode of the photoelectric conversion element by spin coating to form a first sealing portion. The solvent of the raw material solution is 2-propanol, and the solution contained 15 mass% alumina nanoparticles (manufactured by CIK NanoTek Corporation). The first sealing portion was formed to cover faces of the photoelectric conversion element except the face in contact with the glass substrate.

Next, a second sealing portion was formed in a glove box where the oxygen concentration and the moisture concentration were adjusted at 0.1 ppm or less. A cover glass and an UV curable resin were used as the second sealing portion. The cover glass corresponds to the first portion 40a of the second sealing portion, while the UV curable resin corresponds to the second portion 40b of the second sealing portion. The second sealing portion was formed on the first sealing portion such that a second space defined by the first sealing portion, the cover glass, and the UV curable resin was formed.

The solar cell of Example 1 was obtained in the above manner.

The solar cell of Example 1 has a structure as shown in FIG. 7. That is, the photoelectric conversion element 20 was covered such that the photoelectric conversion element 20 was sandwiched between the supporting portion 10 (substrate) and the first sealing portion 30. The first sealing portion 30, the first portion 40a (cover glass) of the cover portion composing the second sealing portion, and the second portion 40b (UV curable resin) of the cover portion composing the second sealing portion defined the second space 53. The ratio of the volume of the first sealing portion 30 to the volume of the exterior body 1 was 0.025%, the thickness of the first sealing portion 30 was 2000 µm, and the minimum of the distance between a surface of the first sealing portion 30 in contact with the second space 53 and the second exposed surface 32 of the first sealing portion 30 was 0.46 µm.

### (Example 2)

In Example 2, the solvent of the raw material solution of the first sealing portion was 2-propanol, and the solution contained 50 g/L formamidinium iodide. Except for that, the solar cell of Example 2 was obtained in the same manner as in Example 1. The solar cell of Example 2 has a structure as shown in FIG. 7, as does the solar cell of Example 1. The ratio of the volume of the first sealing portion 30 to the volume of the exterior body 1 was 0.011%, the thickness of the first sealing portion 30 was 2000 µm, and the minimum of the distance between the surface of the first sealing portion 30 in contact with the second space 53 and the second exposed surface 32 of the first sealing portion 30 was 0.2 µm.

### (Example 3)

The solar cell of Example 3 was obtained in the same manner as in Example 1, except that the raw material solution containing the oxygen concentration adjusting material contained 1.5 mass% alumina nanoparticles (manufactured by CIK NanoTek Corporation) in Example 3. The solar cell of Example 3 has a structure as shown in FIG. 7, as does the solar cell of Example 1. The ratio of the volume of the first sealing portion 30 to the volume of the exterior body 1 was 0.0021%, the thickness of the first sealing portion 30 was 2000 µm, and the minimum of the distance between the surface of the first sealing portion 30 in contact with the second space 53 and the second exposed surface 32 of the first sealing portion 30 was 0.04 µm.

### (Example 4)

In Example 4, CYTOP (CTL-109AE manufactured by AGC Inc.), which is an amorphous fluorine resin, diluted with a special solvent was used as the raw material solution of the first sealing portion. Except for that, the solar cell of Example 4 was obtained in the same manner as in Example 3. The solar cell of Example 4 has a structure as shown in FIG. 7, as does the solar cell of Example 1. Incidentally, CYTOP is a registered trademark of AGC Inc. The ratio of the volume of the first sealing portion 30 to the volume of the exterior body 1 was 0.0011%, the thickness of the first sealing portion 30 was 2000 µm, and the minimum of the distance between the surface of the first sealing portion 30 in contact with the second space 53 and the second exposed surface 32 of the first sealing portion 30 was 0.02 µm.

### (Comparative Example 1)

In a glove box where the oxygen concentration and the moisture concentration were adjusted at 0.1 ppm or less, a cover glass and an UV curable resin were disposed on a glass substrate such that a space defined by the glass substrate, the cover glass, and the UV curable resin was formed and that the photoelectric conversion element was in the sealed space. The solar cell of Comparative Example 1 was obtained in this manner. That is, the exterior body of the solar cell of Comparative Example 1 included no first sealing portion and no second sealing portion.

Since the exterior body of the solar cell of Comparative Example 1 included no first sealing portion including the oxygen concentration adjusting material, the oxygen concentration in the space of the solar cell was 0.1 ppm or less. That is, as for the solar cell of Comparative Example 1, the oxygen concentration in the region in contact with the photoelectric conversion element was 0.1 ppm or less.

### <Measurement of photoelectric conversion efficiency>

The photoelectric conversion efficiency of each of the solar cells of Examples 1 to 4 and Comparative Example 1 was measured.

An electrochemical analyzer (ALS440B manufactured by BAS Inc.) and a xenon light source (BPS X300BA manufactured by Bunkoukeiki Co., Ltd.) were used for the photoelectric conversion efficiency measurement. Before the measurement, the light intensity was calibrated using a silicon photodiode to be 1 Sun (100 mW/cm²). A voltage scan rate was 100 mV/s. Before starting the measurement, advance adjustment by light irradiation, a long period of forward bias application, etc. was not performed. Each solar cell was masked with a black mask having a 0.1 cm² opening portion so as to fix the effective area and reduce influence of scattering light. The masked solar cell was irradiated with light from the masked glass substrate side. The photoelectric conversion efficiency measurement was performed at room temperature in dry air (< 2%RH).

Table 1 shows open-circuit voltages (V_{OC}), short-circuit current densities (Jsc), fill-factors (FF), and photoelectric conversion efficiencies (Eff) measured as described above.

**[Table 1]**

| | Intermediate layer | First sealing portion | V_{OC} (mV) | J_{SC} (mA/cm²) | FF | Eff (%) |
|---|---|---|---|---|---|---|
| Example 1 | Without | Alumina | 1102 | 22.95 | 0.817 | 20.65 |
| Example 2 | Without | Formamidinium iodide | 1091 | 23.13 | 0.803 | 20.28 |
| Example 3 | With | Alumina | 1002 | 23.55 | 0.778 | 18.36 |
| Example 4 | With | Amorphous fluorine resin | 960 | 23.39 | 0.761 | 17.10 |
| Comparative Example 1 | Without | N/A | 1077 | 22.96 | 0.794 | 19.65 |

### <Light resistance test>

A light resistance test was performed for the solar cells of Example 1 and Comparative Example 1.

In the light resistance test, the solar cell was irradiated from the substrate side with about 1 Sun of light for 9 hours. During the irradiation, the voltage and the current of each solar cell was maintained around a maximum power point of the solar cell, and the substrate temperature was maintained at 50°C. The photoelectric conversion efficiency of each of the solar cells of Example 1 and Comparative Example 1 were measured by the above method 0 hours and 9 hours after the light irradiation.

Table 2 shows the photoelectric conversion efficiencies measured 0 hours and 9 hours after the light irradiation for the solar cells of Example 1 and Comparative Example 1 and photo degradation rates of the solar cells of Example 1 and Comparative Example 1.

**[Table 2]**

| | Intermediate layer | First sealing portion | 0 hours after light irradiation Eff (%) | 9 hours after light irradiation Eff (%) | Photo degradation rate (%) |
|---|---|---|---|---|---|
| Example 1 | Without | Alumina | 19.44 | 18.05 | -7.2% |
| Comparative Example 1 | Without | N/A | 19.59 | 17.82 | -9.0% |

### <Thermal resistance test>

A thermal resistance test was performed for the solar cells of Examples 1 to 3 and Comparative Examples 1 to 2.

In the thermal resistance test, each solar cell was maintained at 85°C in a constant-temperature chamber. For Examples 1 and 2 and Comparative Example 1, the thermal resistance test was performed for 100 hours. That is, the solar cells were maintained at 85°C for 100 hours. For Example 3 and Example 4, the thermal resistance test was performed for 70 hours. That is, the solar cells were maintained at 85°C for 70 hours.

After the thermal resistance test, properties of the solar cells were measured by the above method. Table 3 shows the solar cell properties measured.

**Table 3**

| | Intermediate layer | First sealing portion | V_{OC} (mV) | J_{SC} (mA/cm²) | FF | Eff (%) |
|---|---|---|---|---|---|---|
| Example 1 | Without | Alumina | 1045 | 22.53 | 0.781 | 18.39 |
| Example 2 | Without | Formamidinium iodide | 1064 | 22.65 | 0.770 | 18.55 |
| Example 3 | With | Alumina | 977 | 23.33 | 0.756 | 17.23 |
| Example 4 | With | Amorphous fluorine resin | 893 | 22.19 | 0.676 | 13.38 |
| Comparative Example 1 | Without | N/A | 930 | 20.16 | 0.456 | 8.56 |

### <Discussion>

### (Effect of first sealing portion on initial solar cell properties)

Comparison between Examples 1 and 2 and Comparative Example 1 reveals that, as shown in Table 1, introduction of the first sealing portion enhanced the initial photoelectric conversion efficiency. In particular, the improvement of V_{OC} and FF indicates a reduction of defects on the surface of perovskite and at the grain boundaries therein. In other words, it is inferred that a reaction product of the perovskite compound and a small amount of oxygen and a decomposition product of the perovskite were stably present on the surface of the perovskite or at the grain boundaries therein for a long period of time, had such a thickness that the products did not prevent carriers from transferring, and effectively terminated a defect of the perovskite. The above results mean that the oxygen concentration in the region in contact with the photoelectric conversion element was adjusted within the more optimal concentration range (100 ppm or more and 3000 ppm or less) by the first sealing portion.

Comparison between Example 3 and Example 4 reveals that the initial photoelectric conversion efficiency of Example 3 is higher. This indicates that adjustment of the oxygen concentration in the region in contact with the photoelectric conversion element was less sufficient for Example 4 than for Example 3 because the oxygen permeability coefficient of the amorphous fluorine resin used as the first sealing portion of Example 4 is high, specifically, 8.34 × 10⁻¹⁰ cm³·cm/(cm²·s·cmHg) according to a catalog as of July 2018. Hence, it can be said that the initial properties of the perovskite solar cell can further be enhanced when the oxygen permeability coefficient of the oxygen concentration adjusting material is lower than 8.34 × 10⁻¹⁰ cm³·cm/(cm²·s·cmHg).

### (Effect of oxygen concentration on solar cell properties after light resistance test)

Comparison between Example 1 and Comparative Example 1 reveals that, as shown in Table 2, introduction of the oxygen concentration adjusting layer decreased the photo degradation rate and improved the light resistance. This is presumably because, as for the initial properties, the oxygen concentration in the region in contact with the photoelectric conversion element was adjusted within the optimal concentration range by the oxygen concentration adjusting layer and defect termination was sufficiently performed under light irradiation.

### (Effect of oxygen concentration on solar cell properties after thermal resistance test)

Comparison between Examples 1 and 2 and Comparative Example 1 reveals that, as shown in Table 3, introduction of the first sealing portion greatly improved the photoelectric conversion efficiency after the thermal resistance test. Additionally, when Examples 3 and 4 and Comparative Example 1 are compared, the photoelectric conversion efficiency values before and after the thermal resistance test indicate introduction of the first sealing portion reduced degradation in photoelectric conversion efficiency by the thermal resistance test, although Examples 3 and 4 and Comparative Example 1 differ in whether the solar cells have the intermediate layer. Judging from the above, the solar cells of Examples 1 to 4 have a high durability. The solar cell of Comparative Example 1 has a low durability. This is presumably because, as for the initial properties, the oxygen concentration in the sealed space was adjusted within the optimal concentration range by the first sealing portion and defect termination was sufficiently performed under heating. Additionally, when Example 3 and Example 4 are compared, degradation in photoelectric conversion efficiency through the thermal resistance test was reduced more for Example 3 than for Example 4; this indicates that the oxygen concentration in the second space was adjusted within the more optimal concentration range for Example 3 than for Example 4.

### INDUSTRIAL APPLICABILITY

It can be said that the present disclosure can greatly enhance the durability of the solar cell by adjusting the oxygen concentration in the region in contact with the photoelectric conversion element within the low concentration range suitable for perovskite solar cells and that the industrial applicability of the solar cell of the present disclosure is extremely high.

## Claims

1. A solar cell comprising:
a photoelectric conversion element; and
an exterior body surrounding the entire photoelectric conversion element, wherein
the photoelectric conversion element comprises a perovskite compound,
the exterior body comprises a first sealing portion and a second sealing portion,
the first sealing portion comprises an oxygen concentration adjusting material, has a first exposed surface exposed to an outside of the exterior body and a second exposed surface exposed to an inside of the exterior body, and is continuous between the first exposed surface and the second exposed surface, and
the second sealing portion comprises a material having an oxygen permeability coefficient lower than that of the oxygen concentration adjusting material.

2. The solar cell according to claim 1, wherein the exterior body consists of the first sealing portion and the second sealing portion.

3. The solar cell according to claim 1 or 2, wherein the first sealing portion is composed of a supporting portion supporting the photoelectric conversion element.

4. The solar cell according to claim 3, wherein the second sealing portion covers at least a portion of a surface of the photoelectric conversion element supported by the supporting portion.

5. The solar cell according to claim 1 or 2, wherein the second sealing portion comprises a supporting portion supporting the photoelectric conversion element.

6. The solar cell according to claim 5, wherein the first sealing portion covers at least a portion of a surface of the photoelectric conversion element supported by the supporting portion.

7. The solar cell according to claim 6, wherein the first sealing portion is in contact with the surface of the photoelectric conversion element.

8. The solar cell according to claim 7, wherein the first sealing portion comprises: a first layer in contact with the surface of the photoelectric conversion element; and a second layer disposed on the first layer.

9. The solar cell according to any one of claims 5 to 8, wherein the second sealing portion further comprises a cover portion covering at least a portion of a surface of the photoelectric conversion element supported by the supporting portion.

10. The solar cell according to claim 9, wherein the first sealing portion is positioned between the supporting portion and the cover portion.

11. The solar cell according to claim 9 or 10, wherein the first sealing portion is out of contact with the photoelectric conversion element.

12. The solar cell according to any one of claims 9 to 11, wherein the first sealing portion is provided to penetrate at least one selected from the group consisting of the supporting portion and the cover portion from the outside of the exterior body toward the inside of the exterior body.

13. The solar cell according to any one of claims 1 to 12, comprising a first space surrounded by the exterior body, wherein
the photoelectric conversion element is positioned inside the first space.

14. The solar cell according to any one of claims 1 to 13, wherein the oxygen concentration adjusting material comprises at least one selected from the group consisting of an inorganic material and an organic material.

15. The solar cell according to claim 14, wherein the inorganic material is at least one selected from the group consisting of silicon nitride, silicon oxynitride, aluminum oxide, zirconium oxide, silicon oxide, cerium oxide, calcium oxide, iron oxide, zeolite, a porous silica, a porous carbon, a porous ceramic, and a metal.

16. The solar cell according to claim 14, wherein the organic material is at least one selected from the group consisting of formamidinium iodide, formamidinium bromide, formamidinium chloride, ethylammonium iodide, ethylammonium bromide, a carboxylic acid compound, a phosphoric acid compound, a silicic acid compound, a porous coordination polymer, a crown ether, a cyclodextrin, and a resin.

17. The solar cell according to any one of claims 1 to 16, wherein the second sealing portion comprises at least one selected from the group consisting of glass and a resin.

18. The solar cell according to any one of claims 1 to 17, wherein the photoelectric conversion element comprises a first electrode, a photoelectric conversion layer, and a second electrode in this order.

19. The solar cell according to any one of claims 1 to 18, further comprising at least one selected from the group consisting of a moisture getter material and a filler, wherein
at least one selected from the group consisting of the moisture getter material and the filler is provided between the exterior body and the photoelectric conversion element.

20. The solar cell according to any one of claims 1 to 19, wherein an oxygen concentration in a region in contact with the photoelectric conversion element is 100 ppm or more and 3000 ppm or less.

21. The solar cell according to claim 20, wherein an oxygen concentration in the first sealing portion is 100 ppm or more and 3000 ppm or less.

22. The solar cell according to claim 20 or 21, comprising a first space surrounded by the exterior body, wherein
the photoelectric conversion element is positioned inside the first space, and
an oxygen concentration in the first space is 100 ppm or more and 3000 ppm or less.
